# EUROPÄISCHE PATENTSCHRIFT

(11) **EP 4 361 655 B1**
(45) Veröffentlichungstag und Bekanntmachung des Hinweises auf die Patenterteilung: **17.06.2026**
(21) Anmeldenummer: 23206398.2
(22) Anmeldetag: 27.10.2023
(51) Int. Cl.: G01R 31/392, G01R 31/396

(54) **VERFAHREN ZUM ERMITTELN EINES ANTEILS DEFEKTER BATTERIEZELLEN, EIN BATTERIESTEUERGERÄT, EIN COMPUTERPROGRAMM, EIN COMPUTERLESBARES SPEICHERMEDIUM, EINE BATTERIE UND EIN KRAFTFAHRZEUG**
METHOD FOR DETERMINING A PART OF DEFECTIVE BATTERY CELLS, A BATTERY CONTROL DEVICE, A COMPUTER PROGRAM, A COMPUTER-READABLE STORAGE MEDIUM, A BATTERY AND A MOTOR VEHICLE
PROCÉDÉ DE DÉTERMINATION D'UNE PARTIE D'ÉLÉMENTS DE BATTERIE DÉFECTUEUX, CONTRÔLEUR DE BATTERIE, PROGRAMME INFORMATIQUE, SUPPORT D'ENREGISTREMENT LISIBLE PAR ORDINATEUR, BATTERIE ET VÉHICULE AUTOMOBILE

(30) Priorität: 28.10.2022 DE 102022128702
(43) Veröffentlichungstag der Anmeldung: 01.05.2024
(73) Patentinhaber: Webasto SE, 82131 Stockdorf (DE)
(72) Erfinder: Bennetts, David, Stockdorf (DE); Zimnik, Dr., Samantha, Stockdorf (DE)
(74) Vertreter: Nordmeyer, Philipp Werner

(56) Entgegenhaltungen:
- EP-A1- 3 989 330
- DE-A1- 102021 106 060
- US-A1- 2019 198 945
- US-A1- 2022 179 008

## Beschreibung

### Technisches Gebiet

Die vorliegende Erfindung betrifft ein Verfahren zum Ermitteln eines Anteils defekter Batteriezellen in einer Batterie, ein Batteriesteuergerät, ein Computerprogramm, ein computerlesbares Speichermedium, eine Batterie und ein Kraftfahrzeug.

### Stand der Technik

Eine Batterie kann gesunde und defekte Batteriezellen umfassen. Die Batteriezellen der Batterie können über die Zeit und/oder durch Umwelteinflüsse und/oder durch Herstellungsfehler und/oder Herstellungstoleranzen in unterschiedlichen Geschwindigkeiten altern. Dadurch können gesunde Batteriezellen vorzeitig altern und defekt werden. Defekte Batteriezellen weisen einen erhöhten inneren elektrischen Widerstand auf und haben ein anderes Ladeverhalten als gesunde Batteriezellen in der Batterie.

Eine defekte Batteriezelle kann bei einem Ladevorgang oder bei einem Entladevorgang der Batterie zu einer erhöhten Wärmeentwicklung führen und zudem unerwünschte Ausgleichsströme von den gesunden Batteriezellen zu den defekten Batteriezelle innerhalb der Batterie verursachen. Somit können die defekten Batteriezellen die gesunden Batteriezellen in der Batterie und insbesondere in einer Gruppe parallel miteinander verschalteter Batteriezellen schaden.

Deshalb können Batteriezellen einen Trennschalter aufweisen, welcher diese elektrisch von den anderen Batteriezellen einer Gruppe von Batteriezellen abklemmt, wobei der Trennschalter aber keine Rückmeldung an das Batteriemanagementsystem gibt. Deshalb ist es notwendig, den Anteil der defekten und insbesondere der abgeklemmten Batteriezellen in der Batterie zu schätzen und die Teile der Batterie, welche zu viele defekte Batteriezellen aufweisen, elektrisch von der Batterie zu trennen.

Aus der EP 3 951 411 A1 sind ein Verfahren und ein System zum Erkennen von Verbindungsfehlen einer parallelen Verbindungszelle bekannt. Aus der EP 2 343 768 A2 sind ein Batteriesystem und ein Verfahren zur Feststellung des Strombegrenzungszustandes in einem Batteriesystem bekannt. Aus der US 2019/0198945 A1 sind ein Sekundärbatteriesystem und Verfahren zur Diagnose von Anomalien in einem Batteriesatz bekannt. Aus der US 2021/0165054 A1 sind ein Verfahren zur Erkennung von Kontaktierungsfehlern in einem wiederaufladbaren Batteriesatz und ein System zur Durchführung des Verfahrens bekannt. Aus der EP 2 306 214 A3 ist ein Verfahren zur Bestimmung eines Gleichstromwiderstands einer Batterie bekannt. Aus der EP 3 252 914 B1 sind eine Vorrichtung und ein Verfahren zum Erfassen des Öffnens der Stromunterbrechungsvorrichtung einer Batterieeinheit bekannt.

Aus der DE 10 2021 106 060 A1 ist eine Batterieüberwachungseinheit bekannt. Aus der US 2022/0179008 A1 sind ein Batteriediagnosegerät und -verfahren bekannt. Aus der EP 3 989 330 A1 sind ein Gerät und ein Verfahren zur Diagnose eines Batteriedegradationsgrads bekannt.

### Darstellung der Erfindung

Ausgehend von dem bekannten Stand der Technik ist es eine Aufgabe der vorliegenden Erfindung, ein verbessertes Verfahren zum Bestimmen eines Anteils defekter Batteriezellen, sowie ein entsprechendes Batteriesteuergerät, ein Computerprogramm, ein computerlesbares Speichermedium, eine Batterie und ein Kraftfahrzeug bereitzustellen.

Die Aufgabe wird durch ein Verfahren mit den Merkmalen des Anspruchs 1 und/oder 2 gelöst. Vorteilhafte Weiterbildungen des Verfahrens ergeben sich aus den Unteransprüchen sowie der vorliegenden Beschreibung und den Figuren.

Entsprechend wird ein Verfahren zum Bestimmen eines Anteils defekter Batteriezellen einer Gruppe elektrisch parallel geschalteter Batteriezellen in einer Batterie vorgeschlagen, wobei ein Spannungszustand einer Klemmenspannung der Gruppe in Bezug auf einen Ladevorgang und/oder in Bezug auf eine Relaxation der Batterie unter einer Umweltbedingung bestimmt wird und eine Abweichung und eine Veränderungsrate der Abweichung des bestimmten Spannungszustands der Klemmenspannung von dem Spannungszustand der Klemmenspannung derselben Gruppe aus einem vorherigen Ladevorgang und/oder einer vorherigen Relaxation unter derselben Umweltbedingung berechnet wird, wobei aus der berechneten Abweichung und aus der Veränderungsrate der Abweichung der Anteil der defekten Batteriezellen in der Gruppe bestimmt wird.

Ergänzend oder alternativ wird ein Verfahren zum Bestimmen eines Anteils defekter Batteriezellen einer Gruppe elektrisch parallel geschalteter Batteriezellen in einer Batterie vorgeschlagen, wobei der Spannungszustand der Klemmenspannung der Gruppe in Bezug auf den Ladevorgang und/oder in Bezug auf die Relaxation der Batterie unter einer Umweltbedingung bestimmt wird und eine Abweichung und eine Veränderungsrate der Abweichung des bestimmten Spannungszustands der Klemmenspannung von einem Spannungszustand der Klemmenspannung von zumindest einer anderen Gruppe der Batterie und/oder von einem Durchschnittswert des Spannungszustands der jeweiligen Klemmenspannung von zumindest zwei Gruppen der Batterie berechnet wird, wobei aus der berechneten Abweichung und aus der Veränderungsrate der Abweichung der Anteil der defekten Batteriezellen in der Gruppe bestimmt wird. Beispielsweise kann mittels eines Vergleichs der Abweichung mit einem gespeicherten Abweichungsschwellenwert der Anteil der defekten Batteriezellen in der Gruppe bestimmt werden.

Ergänzend kann eine Veränderungsrate der Abweichung mittels eines Vergleichs der berechneten Abweichung in Bezug auf einen aktuellen Ladevorgang mit der berechneten Abweichung aus zumindest einem vorherigen Ladevorgang, insbesondere in Bezug auf einen Referenzwert aus einem vorherigen Ladevorgang, bestimmt werden. Beispielsweise kann die berechnete Abweichung aus dem vorherigen Ladevorgang jeweils als Referenzwert für die Bestimmung der Veränderungsrate verwendet werden. Wenn beispielsweise die Veränderungsrate einen Schwellenwert in Bezug zum Referenzwert überschreitet, insbesondere wenn ein Sprung in der Veränderungsrate detektiert wird, kann bestimmt werden, dass ein Tausch von einer alten Gruppe mit einer neuen Gruppe stattgefunden hat. Für diesen Fall kann die berechnete Abweichung als ein neuer Referenzwert gespeichert werden, wobei die jeweilige Gruppe bei einem Überschreiten der Veränderungsrate über den besagten Schwellenwert konnektiert bleibt. Wenn die Veränderungsrate den Schwellenwert unterschreitet, insbesondere kein Sprung in der Veränderungsrate detektiert wird, kann bestimmt werden, dass die berechnete Abweichung in Bezug auf den Ladevorgang durch eine Alterung der Batteriezellen in der Gruppe und/oder durch Fertigungstoleranzen bewirkt ist.

Hierdurch ergibt sich der Vorteil, dass ein Fehlalarm und eine fehlerhafte Diskonnektierung der Gruppe bei einem Tausch von einer alten Gruppe mit einer neuen Gruppe in dem Batteriesystem vermieden werden kann. Somit können die besagten Verfahren auch in Batteriesystemen verwendet werden, in welchen neue und gebrauchte Gruppen Batteriezellen verwendet werden, also ein sogenanntes Second-Life-Batteriesystem.

Die Umweltbedingung kann eine auf eine reproduzierbare Situation begrenzte Umweltbedingung sein. Mit anderen Worten kann die Umweltbedingung so gewählt sein, dass sie bei einem weiteren Ladevorgang reproduziert werden kann.

Eine auf eine reproduzierbare Situation begrenzte Umweltbedingung kann eine Beschränkung der Bestimmung des Spannungszustands der Klemmenspannung auf einen Parameter sein. Der Parameter kann beispielsweise ein Aufladestrom oder Entladestrom und/oder eine Temperatur und/oder ein Ladezustand der Batterie sein. Der Spannungszustand der Klemmenspannung kann in Bezug auf den besagten Parameter bestimmt werden.

Die Batterie kann für eine Verwendung in einem Kraftfahrzeug ausgebildet und insbesondere als ein verteiltes Batteriesystem vorgesehen sein. Die Batterie oder das Batteriesystem können somit zumindest eine Gruppe von jeweils elektrisch parallel geschalteten Batteriezellen umfassen. Die Gruppen in der Batterie können untereinander elektrisch in Serie geschalten sein. Die jeweilige Gruppe in der Batterie kann eine Messeinrichtung zur Messung einer elektrischen Spannung, beispielsweise der Klemmenspannung, und/oder eines Aufladestroms oder eines Entladestroms aufweisen, welche über eine Datenleitung mit einem Batteriesteuergerät verbunden ist.

Eine Ladestartzeit des Ladevorgangs kann mittels einer Messung des Aufladestroms oder Entladestroms und/oder mittels eines Empfangens einer Benutzereingabe erkannt werden, wobei die Ladestartzeit als der Zeitpunkt bestimmt werden kann, an welchem der gemessene Aufladestrom oder Entladestrom ungleich null ist.

Das Batteriesteuergerät kann den Spannungszustand der Klemmenspannung der jeweiligen Gruppe beispielsweise erst dann bestimmen, wenn die Umweltbedingung des aktuellen Ladevorgangs dieselbe oder eine ähnliche Umweltbedingung wie die Umweltbedingung des vorhergehenden Ladevorgangs ist.

In Bezug auf einen Ladevorgang und/oder auf eine Relaxation kann vor und/oder während und/oder nach dem Ladevorgang und/oder der Relaxation bedeuten. Eine Relaxation kann eine Zeit einer Inaktivität oder eine Ruhezeit der Batterie umfassen.

Der Durchschnittswert kann den Durchschnitt des Spannungszustands der Klemmenspannung, insbesondere des Spannungslevels und/oder des Spannungsabfalls, von zumindest zwei Gruppen oder aller Gruppen der Batterie sein.

Ergänzend kann die Ladestartzeit mittels des Aufladestroms oder Entladestroms der Ladevorrichtung, beispielsweise mittels eines Batteriesteuergeräts, derart berechnet werden, dass ein mittels einer Benutzereingabe empfangenes Ladeziel zur Ladezielzeit, wie beispielsweise um 06:00 Uhr morgens, stets erreicht wird. Das Ladeziel kann dabei einen Ladesollzustand der Batterie nach dem Ladevorgang vorgeben. Durch das Starten des Ladevorgangs nach der Ruhezeit kann eine Verfälschung der Schätzung durch eine Hysterese der Batteriezellen beim Entlade- und Ladevorgang reduziert werden.

Während des Ladevorgangs, beispielsweise während einer Anlaufphase, insbesondere einer Konstantstromphase des Ladevorgangs, kann mittels der Messeinrichtung in Zeitabständen eine Messung der Klemmenspannung der jeweiligen Gruppe durchgeführt werden und optional der Messwert zusammen mit dem Messzeitpunkt in einem Speicher gespeichert werden.

Aus dem jeweiligen Datenpaar des Messwerts und des Messzeitpunkts der Klemmenspannung der Gruppe kann beispielsweise mittels einer Prozessoreinheit der Spannungszustand der Klemmenspannung während des Ladevorgangs bestimmt werden. Die Zeitabstände können periodisch ausgebildet sein oder nach einer vorgegebenen Anzahl an Datenpaaren während der Anlaufphase, insbesondere während der Konstantstromphase des Ladevorgangs ausgerichtet sein. Die Anzahl der vorgegebenen Datenpaare kann während der Anlaufphase, insbesondere während der Konstantstromphase höher sein als in anderen Phasen des Ladevorgangs. Beispielsweise kann der Zeitabstand, wie beispielsweise eine Abtastrate, während der Anlaufphase des Ladevorgangs für eine bessere Datenerfassung verkürzt werden.

Ergänzend kann der Spannungszustand der Klemmenspannung während eines Anstiegs der Klemmenspannung mit einem Referenzgradienten bestimmt werden.

Der Spannungszustand der Klemmenspannung kann nach dem Ladestartzeitpunkt, beispielsweise in einer ersten Hälfte oder in einem ersten Viertel der Ladezeit nach der Ladestartzeit, bestimmt werden.

Der Spannungszustand der Klemmenspannung der jeweiligen Gruppe kann unter zumindest einer Umweltbedingung bestimmt werden.

Die Umweltbedingung kann ein Parameter sein, wie beispielsweise eine Temperatur und/oder ein Ladezustand der Batterie und/oder eine Ruhezeit der Batterie. Die Umweltbedingung des Ladevorgangs kann dieselbe oder eine ähnliche Umweltbedingung des vorherigen Ladevorgangs sein, wenn die jeweiligen Parameter der Umweltbedingung jeweils gleich sind und/oder sich in einem Toleranzintervall um einen Referenzwert des jeweiligen Parameters befinden.

Die Ruhezeit kann beispielsweise zumindest teilweise die Relaxationszeit der Batterie betragen, wie beispielsweise mindestens drei Viertel der Relaxationszeit. Beispielsweise wird der Spannungszustand der Klemmenspannung bestimmt, wenn die Ruhezeit zumindest die Relaxationszeit beträgt.

Eine Abweichung des Spannungszustands der Klemmenspannung der Gruppe aus dem Ladevorgang kann mit dem Spannungszustand der Klemmenspannung derselben Gruppe aus einen vorherigen Ladevorgang unter derselben Umweltbedingung und/oder mit dem Spannungszustand der Klemmenspannung einer anderen Gruppe der Batterie aus demselben oder einem vorherigen Ladevorgang unter derselben Umweltbedingung berechnet werden. Die andere Gruppe kann dabei baugleich mit der betrachteten Gruppe sein. Dabei kann eine baugleiche Gruppe eine solche Gruppe sein, welche die gleichen Umweltbedingungen seit der Fertigung wie die Gruppe durchlaufen hat, beispielsweise in Bezug auf Temperatur, Ladestrom, Entladegeschwindigkeit (Fahrstil), Lebensalter und Ladezyklen. So kann die baugleiche Gruppe eine solche Gruppe sein, bei welcher die Veränderungsrate der Abweichung den Schwellenwert unterschreitet. Eine andere Gruppe, bei welcher die Veränderungsrate der Abweichung den Schwellenwert zumindest einmal überschritten hat, kann für die Berechnung der Abweichung ausscheiden. Daher kann die oben erwähnte Erkennung eines Sprungverhaltens geeignet sein, um diskonnektierte Zellen trotz verschiedener "Alterung" mit niedriger Fehlaussage zu erkennen. Beispielsweise kann ein Batteriesteuergerät hierzu eine Prozessoreinheit aufweisen, welche die Abweichung berechnet.

Beispielsweise kann die Abweichung berechnet werden, indem die Beträge der Differenzen zu den jeweiligen Messpunkten addiert werden. Die Abweichung kann somit als eine Summe der Differenzbeträge der Messwerte des Spannungszustands der Klemmenspannung ausgebildet sein, beispielsweise als eine Summe der Differenzen der jeweiligen Datenpaare zu den jeweiligen Zeitpunkten. Ergänzend kann der Spannungszustand der Klemmenspannung der Gruppe aus dem aktuellen Ladevorgang zusammen mit der Umweltbedingung in dem Speicher gespeichert werden. Ergänzend kann mittels eines Filterelements der jeweilige Spannungszustand der Klemmenspannung für eine bessere Datenverarbeitung durch eine Prozessoreinheit, insbesondere einem Mikrocontroller, logarithmiert und dann die jeweilige Abweichung berechnet werden.

Ergänzend oder alternativ kann die Abweichung aus einem Vergleich der Klemmenspannung der Gruppe mit einem Referenzwert, welcher beispielsweise ein Durchschnittswert der Zeitverläufe der Klemmenspannung der anderen Gruppen aus einem vorherigen Ladevorgang unter derselben Umweltbedingung und/oder ein Durchschnittswert der Zeitverläufe der Klemmenspannung der anderen Gruppen aus dem aktuellen Ladevorgang sein kann, berechnet werden.

Wenn die berechnete Abweichung des Spannungszustands der Klemmenspannung einen Abweichungsschwellenwert, welcher beispielsweise ein Spannungsschwellenwert und/oder ein Widerstandsschwellenwert sein kann, überschreitet, kann ein zu dem jeweiligen Abweichungsschwellenwert zugehöriger Anteil der defekten Batteriezellen bestimmt werden.

Wenn der Anteil der defekten Batteriezellen unter einen Anteilsschwellenwert, wie beispielsweise 50 Prozent defekte Batteriezellen in der Gruppe, unterschreitet, kann die Gruppe über eine Schaltanordnung elektrisch mit der Batterie verbunden bleiben.

Wenn der Anteil der defekten Batteriezellen den Anteilsschwellenwert überschreitet, kann die Gruppe mittels zumindest eines Schaltelements der Schaltanordnung elektrisch von den anderen Gruppen der Batterie getrennt und/oder ein Aufladestrom oder ein Entladestrom begrenzt werden und/oder eine Warnmeldung ausgegeben werden. Der aktuelle Ladevorgang der Gruppe mit zu vielen defekten Batteriezellen wird somit nicht fortgesetzt. Nach der Ausgabe der Warnmeldung kann das Kraftfahrzeug zur einer Werkstatt gebracht und die betroffene Gruppe ausgewechselt werden. Damit wäre eine Periode mit geringer Leistung gekürzt. Die Warnmeldung kann hierzu eine Aufforderung an einen Benutzer umfassen, eine Werkstatt aufzusuchen.

Insbesondere sieht das Verfahren vor, dass der Spannungszustand der Klemmenspannung der Gruppe in Bezug auf einen Ladevorgang unter einer auf eine reproduzierbare Situation begrenzenden Umweltbedingung bestimmt wird und die Abweichung des bestimmten Spannungszustands der Klemmenspannung einerseits von dem Spannungszustand der Klemmenspannung derselben Gruppe aus einem vorherigen Ladevorgang unter derselben Umweltbedingung und/oder andererseits von dem Spannungszustand der Klemmenspannung von zumindest einer anderen Gruppe der Batterie und/oder von einem Durchschnittswert des Spannungszustands der jeweiligen Klemmenspannung von zumindest zwei Gruppen der Batterie berechnet wird. Der Spannungszustand der Klemmenspannung der zumindest einen anderen Gruppe und/oder der Durchschnittswert des Spannungszustands der jeweiligen Klemmenspannung von zumindest zwei Gruppen der Batterie können dabei aus demselben Ladevorgang und/oder aus einer einem vorherigen Ladevorgang ergänzend unter derselben Umweltbedingung sein.

Das Verfahren kann auch vorsehen, dass der Spannungszustand der Klemmenspannung der Gruppe in Bezug auf eine Relaxation unter einer auf eine reproduzierbare Situation begrenzenden Umweltbedingung bestimmt wird und die Abweichung des bestimmten Spannungszustands der Klemmenspannung einerseits von dem Spannungszustand der Klemmenspannung derselben Gruppe aus einer vorherigen Relaxation unter derselben Umweltbedingung und/oder andererseits von dem Spannungszustand der Klemmenspannung von zumindest einer anderen Gruppe der Batterie und/oder von einem Durchschnittswert des Spannungszustands der jeweiligen Klemmenspannung von zumindest zwei Gruppen der Batterie berechnet wird. Der Spannungszustand der Klemmenspannung der zumindest einen anderen Gruppe und/oder der Durchschnittswert des Spannungszustands der jeweiligen Klemmenspannung von zumindest zwei Gruppen der Batterie können dabei aus derselben Relaxation und/oder aus einer vorherigen Relaxation ergänzend unter derselben Umweltbedingung sein.

Weiterhin kann das Verfahren vorsehen, dass der Spannungszustand der Klemmenspannung der Gruppe in Bezug auf einen Ladevorgang und eine Relaxation unter einer auf eine reproduzierbare Situation begrenzenden Umweltbedingung bestimmt wird und die Abweichung des bestimmten Spannungszustands der Klemmenspannung von dem Spannungszustand der Klemmenspannung derselben Gruppe aus einem vorherigen Ladevorgang und einer vorherigen Relaxation unter derselben Umweltbedingung berechnet wird. Die vorherige Relaxation kann dabei vor und/oder nach dem vorherigen Ladevorgang sein.

Das Verfahren kann auch vorsehen, dass der Spannungszustand der Klemmenspannung der Gruppe in Bezug auf einen Ladevorgang und eine Relaxation unter einer auf eine reproduzierbare Situation begrenzenden Umweltbedingung bestimmt wird und die Abweichung des bestimmten Spannungszustands der Klemmenspannung von dem Spannungszustand der Klemmenspannung von zumindest einer anderen Gruppe der Batterie und/oder von einem Durchschnittswert des Spannungszustands der jeweiligen Klemmenspannung von zumindest zwei Gruppen der Batterie berechnet wird. Der Spannungszustand der Klemmenspannung der zumindest einen anderen Gruppe und/oder der Durchschnittswert des Spannungszustands der jeweiligen Klemmenspannung von zumindest zwei Gruppen der Batterie können dabei aus demselben Ladevorgang und Relaxation oder aus einem vorherigen Ladevorgang und einer vorherigen Relaxation ergänzend unter jeweils derselben Umweltbedingung sein. Die vorherige Relaxation kann dabei vor und/oder nach dem vorherigen Ladevorgang sein. Ergänzend können auch Kombinationen der besagten Ausführungsformen des Verfahrens vorgesehen sein.

Hierdurch ergibt sich der Vorteil, dass ein Gesundheitszustand der Batterie ohne Unterbrechung eines Ladevorgangs an unterschiedlichen Ladevorrichtungen unter verschiedenen Umweltbedingungen zuverlässig geschätzt werden kann. Insbesondere ist keine Unterbrechung des Ladevorgangs für die Schätzung notwendig. Eine Unterbrechung des Ladevorgangs durch das Batteriesteuergerät kann eine externe Ladevorrichtung irritieren, sodass diese von einem vorzeitigen Beenden des Ladevorgangs ausgehen und somit den Ladevorgang vorzeitig beenden kann. Durch oben beschriebenes Verfahren muss ein Ladevorgang nicht unterbrochen werden, da beispielsweise zu Beginn des Ladevorgangs, insbesondere während der ersten Hälfte des Ladevorgangs ab der Ladestartzeit, der Anteil der defekten Batteriezellen geschätzt wird. Hierdurch kann die Schätzung unabhängig von der Ladevorrichtung durchgeführt werden.

Durch den Vergleich des Spannungszustands der Klemmenspannung der Gruppe während des Ladevorgangs mit der dem Spannungszustand der Klemmenspannung derselben Gruppe aus einem vorherigen Ladevorgang unter derselben Umweltbedingung oder mit dem Verlauf der Klemmenspannung einer anderen Gruppe der Batterie während des aktuellen Ladevorgangs ergibt sich weiterhin der Vorteil, dass weniger Speicher für Referenzdaten benötigt wird. Solche Referenzdaten müssen zudem aufwändig in einem Labortest gesammelt und in dem Speicher gespeichert werden. Bei dem oben verwendeten Verfahren muss nur eine begrenzte Zahl von Zeitverläufen aus dem vorherigen Ladevorgang zusammen mit der jeweiligen Umweltbedingung in dem Speicher gespeichert werden. Sobald die Umweltbedingung dieselbe oder zumindest eine innerhalb eines Toleranzintervalls ähnliche Umweltbedingung ist, wird der Spannungszustand von dem Batteriesteuergerät bei einem aktuellen Ladevorgang erneut bestimmt und mit dem Spannungszustand der Klemmenspannung aus dem vorherigen Ladevorgang verglichen. Durch das Vergleichen während des Betriebs der Batterie kann somit auf einen umfangreichen Referenzdatensatz verzichtet werden. Dabei kann die begrenzte Zahl von Zeitverläufen eine derartige Anzahl an Ladevorgängen umfassen, dass ein Sprungverhalten in der Veränderungsrate der Abweichung detektiert werden kann, selbst wenn dieses erst nach mehreren Ladezyklen auftritt und in den ersten Ladezyklen nur geringe Veränderungsraten auftreten, die nicht auf eine Diskonnektivität schließen lassen.

Durch die Schätzung des Anteils der defekten Batteriezellen in einer der Gruppen in der Batterie ergibt sich zudem der Vorteil, dass einzelne defekte Gruppen elektrisch von der Batterie getrennt werden können und ein restlicher Teil der Batterie umfassend die anderen Gruppen zumindest weiter betrieben werden kann. Zudem kann eine schädigende Wirkung der defekten Batteriezellen auf gesunde Batteriezellen, beispielsweise durch eine Wärmeentwicklung und/oder durch Ausgleichsströme zwischen den Batteriezellen und/oder den Gruppen von Batteriezellen, reduziert werden.

Der Spannungszustand der Klemmenspannung der Gruppe kann einerseits während des Ladevorgangs, insbesondere während eines Entladevorgangs, und/oder der Relaxation und/oder andererseits jeweils vor und/oder nach dem Ladevorgang, insbesondere vor/und oder nach dem Entladevorgang, und/oder der Relaxation bestimmt werden. Mit anderen Worten, die Bestimmung der Klemmenspannung kann während dem Ladevorgang und ergänzend während der Relaxation, also vor und/oder nach dem Ladevorgang, bestimmt werden.

Der Ladevorgang kann ein Aufladevorgang oder ein Entladevorgang sein. Dabei kann der Aufladevorgang ein bevorzugter Zustand für das Verfahren sein, da während des Aufladevorgangs das Kraftfahrzeug stillsteht und es typerweise keine Spannungsstörungen durch Last vom Antrieb oder von regenerativem Bremsen gibt. Eine Abweichung kann entsprechend genauer berechnet werden.

Ergänzend oder alternativ kann die Klemmenspannung der Gruppe einerseits nach dem Ladevorgang und einer anschließenden Relaxation oder andererseits nach der Relaxation und einem anschließenden Ladevorgang bestimmt werden. Der Spannungszustand der Klemmenspannung kann auch nach dem Ladevorgang bei einem Relaxieren der Batterie durchgeführt werden.

Ergänzend oder alternativ kann der Spannungszustand während des Ladevorgangs, insbesondere während eines Auflade- und/oder eines Entladevorgangs ergänzend vor oder nach einer Relaxation der Batterie bestimmt werden.

Ergänzend oder alternativ kann die Klemmenspannung der Gruppe vor und/oder während und/oder nach einer Relaxation bestimmt werden.

Ergänzend oder alternativ kann der Spannungszustand während einer Ruhezeit der Batterie bestimmt werden, welche zumindest teilweise einer Zeit der Relaxation beträgt. Hierdurch kann eine Dauer der Bestimmung des Spannungszustands reduziert werden.

Das Bestimmen des Spannungszustands der Klemmenspannung kann ein Bestimmen eines Spannungsabfalls bei einem Beenden des Ladevorgangs und/oder bei einem Beenden des Entladevorgangs umfassen. Mit anderen Worten, ein Spannungsabfall kann bei einem Beenden des Ladevorgangs, insbesondere eines Lade- und/oder Entladevorgangs, mit dem Spannungsabfall der Gruppe aus einem vorherigen Ladevorgang und/oder mit dem Spannungsabfall der anderen Gruppe der Batterie verglichen werden. Der Spannungszustand oder insbesondere das Spannungslevel wird nach der Relaxation der Batterie bestimmt und eine Abweichung des Spannungszustands oder insbesondere des Spannungslevels der Gruppe unter einer Umweltbedingung von derselben Gruppe aus einem vorherigen Ladevorgang unter derselben Umweltbedingung und/oder von einer anderen Gruppe der Batterie berechnet. Insbesondere kann während der Relaxationszeit ein Balancing der Batterie bis zur Bestimmung der Abweichung ausgesetzt oder pausiert werden.

Der Anteil der defekten Batteriezellen in der Gruppe kann mittels einer Entscheidungsfunktion, beispielsweise einer Entscheidungsmatrix, aus der Abweichung, insbesondere aus dem Abweichungsschwellenwert bestimmt werden. Mit anderen Worten, die Entscheidungsfunktion kann die Abweichung und/oder den Abweichungsschwellenwert auf eine Anzahl der defekten Batteriezellen und/oder einen Anteil defekter Batteriezellen an der Gesamtzahl der Batteriezellen der Gruppe abbilden. Die Entscheidungsfunktion kann beispielsweise aus Literaturdaten und/oder aus Testdaten gewonnen werden. Insbesondere kann die Entscheidungsfunktion als eine Entscheidungsmatrix ausgebildet sein, welche den die Abweichung und/oder den Abweichungsschwellenwert dem Anteil der defekten Batteriezellen zuordnet. Die Entscheidungsmatrix kann beispielsweise als eine Datenbank ausgebildet sein. Hierdurch ergibt sich der Vorteil, dass mittels einer Spannungsmessung an der Gruppe der Anteil der defekten Batteriezellen geschätzt werden kann.

Bei einem Überschreiten der Abweichung über einen mit der Umweltbedingung variierenden Abweichungsschwellenwert kann der Anteil der defekten Batteriezellen in der Gruppe, beispielsweise der Anteil der elektrisch von der Gruppe diskonnektierten Batteriezellen, bestimmt werden. Mit anderen Worten, der Schwellenwert kann ein Spannungsschwellenwert und/oder ein Widerstandsschwellenwert sein, welcher mit einer Differenz zwischen zumindest einem Parameter des aktuellen Ladevorgangs mit dem entsprechenden Parameter des vorherigen Ladevorgangs variiert. Wenn beispielsweise ein Temperaturwert der Umweltbedingung im aktuellen Ladevorgang doppelt so hoch ist wie der Temperaturwert der Umweltbedingung aus dem vorherigen Ladevorgang, kann der Abweichungsschwellenwert ebenfalls doppelt so hoch sein wie der Abweichungsschwellenwert, bei welchem die Temperaturwerte der Umweltbedingung aus dem aktuellen und vorherigen Ladevorgang die gleichen sind. Hierdurch können Proportionalitätsbeziehungen zwischen der Klemmenspannung und der jeweiligen Umweltbedingung genutzt werden, um eine Menge an Vergleichsdaten und damit einen Speicherbedarf zu reduzieren.

Bei einem Überschreiten des Anteils der defekten Batteriezellen über einen Anteilsschwellenwert, insbesondere bei dem Überschreiten der Abweichung über den zum jeweiligen Anteil der defekten Batteriezellen zugehörigen Abweichungsschwellenwert, kann die Gruppe mittels einer Schaltanordnung von der Batterie elektrisch getrennt und/oder ein Aufladestrom oder ein Entladestrom begrenzt werden und/oder eine Warnmeldung ausgegeben werden. Mit anderen Worten, wenn die Anzahl der defekten Batteriezellen eine maximal erlaubte Anzahl defekter Batteriezellen, welche durch den Anteilsschwellenwert abgebildet werden kann, überschreitet, kann die Gruppe elektrisch von der Schaltanordnung und damit von der Batterie getrennt werden. Mittels der Entscheidungsfunktion, insbesondere der Entscheidungsmatrix, kann der Abweichungsschwellenwert auf den Anteilsschwellenwert abgebildet werden. Wenn der Abweichungsschwellenwert und/oder der Anteilsschwellenwert überschritten werden, kann die Gruppe elektrisch getrennt werden. Hierdurch ergibt sich der Vorteil, dass die Batterie zumindest teilweise noch einsatzfähig bleibt und eine schädigende Wirkung der defekten Batteriezellen in der Gruppe begrenzt wird. Im Fall eines begrenzten Entladestroms kann das Kraftfahrzeug in einem eingeschränkten Limp-Home-Modus, also einem Notbetrieb oder Notlaufmodus, betrieben werden, um damit zu einer Werkstatt fahren zu können. Beispielsweise können in dem Limp-Home-Modus nur diejenigen Gruppen des Batteriesystems konnektiert sein, deren Anteil defekter Batteriezellen den Anteilsschwellenwert unterschreitet.

Während des Ladevorgangs kann der Spannungszustand der Klemmenspannung und/oder ein elektrischer Widerstand von derselben Gruppe und/oder von der zumindest einen anderen Gruppe unter der Umweltbedingung bestimmt werden und zusammen mit der Umweltbedingung in einem Speicher gespeichert werden. Mit anderen Worten, nach Ablauf der Ruhezeit können ein Parameter einer Umweltbedingung empfangen und der Spannungszustand der Klemmenspannung zusammen mit dem Parameter in dem Speicher gespeichert werden. Der Parameter der Umweltbedingung kann beispielsweise eine Temperatur und/oder ein Ladezustand der Batterie während der Ruhezeit und/oder die Ruhezeit sein. Die jeweiligen Parameter können mittels einer Sensoreinheit bestimmt und über eine Datenverbindung empfangen werden, wie beispielsweise von dem Batteriesteuergerät.

Ergänzend oder alternativ kann aus einem Aufladestrom oder einem Entladestrom und einer Klemmenspannung der Gruppe ein innerer elektrischer Widerstand der Gruppe bestimmt werden. Mittels einer Veränderung des internen elektrischen Widerstands kann ebenfalls ein Anteil der defekten Batteriezellen in der Gruppe von dem Batteriesteuergerät bestimmt werden. Der elektrische Widerstand der Gruppe kann hierzu in einem aktuellen Ladevorgang, beispielsweise zur Ladestartzeit, bestimmt und in dem Speicher gespeichert werden. Der jeweilige Abweichungsschwellenwert kann dazu einen Spannungsschwellenwert und/oder einen Widerstandsschwellenwert umfassen, welche jeweils mittels der Entscheidungsfunktion auf den Anteilsschwellenwert abgebildet werden können.

Insbesondere kann die Abweichung des Zeitverlaufs und/oder des elektrischen Widerstands dann bestimmt werden, wenn bei dem Ladevorgang die gleiche oder eine ähnliche Umweltbedingung wie bei dem vorherigen Ladevorgang mittels einer Messung der jeweiligen Parameter bestimmt wird. Mittels der Speicherung können der Spannungszustand der Klemmenspannung und/oder der Widerstand für einem folgenden Ladevorgang mit derselben Umweltbedingung oder zumindest einer innerhalb eines Toleranzbereichs ähnlichen Umweltbedingung jeweils als Referenzwert verwendet werden.

Hierdurch ergibt sich der Vorteil, dass der Anteil der defekten Batteriezellen einerseits mittels des Vergleichs der Zeitverläufe der Klemmenspannung der Gruppe und/oder mittels eines Vergleichs des inneren Widerstands von dem Batteriesteuergerät unter verschiedenen Umweltbedingungen besser geschätzt werden kann.

Es kann der Spannungszustand der Klemmenspannung und/oder der elektrische Widerstand von derselben Gruppe unter der Umweltbedingung und/oder von der zumindest einen anderen Gruppe optional unter derselben Umweltbedingung während einer Anlaufphase des Ladevorgangs, insbesondere bei einem Start des Ladevorgangs, bestimmt werden. Mit anderen Worten, der elektrische Widerstand kann bei dem Start des Ladevorgangs bestimmt werden. Beim Start des Ladevorgangs mit einem Aufladestrom oder Entladestrom kann ein Spannungssprung entstehen, wobei mittels des Spannungssprungs beim Start des Ladevorgangs der Widerstand bestimmt wird. Dabei kann der Spannungssprung ein Steigungsverhalten der Spannung bezeichnen und nicht eine sprunghafte Differenz zwischen der Veränderungsrate der Abweichung des Spannungszustands der Klemmenspannung bei einer Diskonnektierung der Gruppen. Der Spannungszustand der Klemmenspannung kann während der Anlaufphase des Ladevorgangs bestimmt werden, wobei die Anlaufphase des Ladevorgangs einen konstanten Aufladestrom oder Entladestrom aufweist. Insbesondere kann ein konstantes Ladestromlimit während der Anlaufphase für ein Erzeugen einer reproduzierbaren Umweltbedingung gesetzt werden, welches beispielsweise derart niedrig gewählt sein kann, dass es von verschiedenen Ladevorrichtungen erreicht werden kann. Ergänzend kann eine Abtastrate für das Bestimmen des Spannungszustands der Klemmenspannung während der Anlaufphase, insbesondere während einer Konstantstromphase des Ladevorgangs, erhöht sein.

Zur Ladestartzeit, also zum Start des Ladevorgangs, können der Spannungszustand und/oder der Widerstand der Gruppe bestimmt werden. Beispielsweise können während einer ersten Hälfte oder einem ersten Viertel der Ladezeit ab der Ladestartzeit, also ab dem Start des Ladevorgangs, der Spannungszustand der Klemmenspannung und/oder der elektrische Widerstand der Gruppe bestimmt werden. Insbesondere kann eine Abweichung des Widerstands aus einer Differenz eines Spannungssprungs der Klemmenspannung zur Ladestartzeit bestimmt werden. Hierdurch ergibt sich der Vorteil, dass ein Einfluss der Umweltbedingung auf das Ladeverhalten reduziert werden kann.

Der Spannungszustand der Klemmenspannung und/oder der elektrische Widerstand kann unter mehreren Umweltbedingungen bestimmt und in dem Speicher gespeichert werden. Der Speicher kann beispielsweise als eine Datenbank ausgebildet sein, unter welcher der Spannungszustand der Klemmenspannung und/oder der elektrische Widerstand unter der jeweiligen Umweltbedingung kategorisiert gespeichert sind.

Hierdurch ergibt sich der Vorteil, dass die Schätzung der defekten Batteriezellen von der Umweltbedingung nicht verfälscht wird. Zusätzlich kann mittels des Speicherns unter mehreren Umweltbedingungen die Schätzung für verschiedene Umweltbedingungen wiederholend durchgeführt werden. Dadurch kann weiterhin ein Schätzintervall verkürzt werden.

Eine Abweichung des elektrischen Widerstands von dem elektrischen Widerstand derselben Gruppe aus dem vorherigen Ladevorgang unter derselben Umweltbedingung und/oder von dem elektrischen Widerstand der zumindest einen anderen Gruppe unter derselben Umweltbedingung und/oder von einem Durchschnittswert der elektrischen Widerstände kann von zumindest zwei Gruppen der Batterie berechnet werden. Mit anderen Worten, die Abweichung des Spannungszustands der Klemmenspannung und/oder die Abweichung des Widerstands können nur dann bestimmt werden, wenn der aktuelle Ladevorgang dieselbe Umweltbedingung bezüglich der vom Batteriesteuergerät gemessenen Parameter erfüllt wie der vorherige Ladevorgang. Die Umweltbedingung des aktuellen Ladevorgangs kann zudem dieselbe Umweltbedingung des vorherigen Ladevorgangs sein, wenn sich der jeweilige Parameter zur Bestimmung der Umweltbedingung jeweils in einem Toleranzintervall um den jeweiligen Parameterwert der Umweltbedingung des vorherigen Ladevorgangs befindet.

Insbesondere können derjenige gespeicherte Spannungszustand der Klemmenspannung und/oder der elektrische Widerstand für die Berechnung der Abweichung verwendet werden, deren vorherige Ladevorgang dieselbe Umweltbedingung aufweist wie der aktuelle Ladevorgang. Hierdurch ergibt sich der Vorteil, dass die Schätzung mittels eines zusätzlichen Parameters durchgeführt werden kann. Weiterhin ergibt sich hierdurch der Vorteil, dass eine Auswirkung der Umweltbedingung auf das Schätzergebnis reduziert werden kann, da die Bestimmung des Widerstandswerts weniger mit variierenden Parametern der Umweltbedingung schwankt.

Die Umweltbedingung kann als Parameter einen Aufladestrom oder einen Entladestrom und/oder eine Temperatur und/oder einen Ladezustand der Batterie und/oder eine Ruhezeit der Batterie umfassen oder sein. Die Umweltbedingung kann ein Aufladestromintervall oder ein Entladestromintervall und/oder ein Temperaturintervall und/oder ein Ladezustandsintervall und/oder ein Ruhezeitintervall sein. Mit anderen Worten, die Umweltbedingung kann zumindest ein Parameterintervall verwenden, welches zumindest ein Toleranzintervall aus einem Aufladestromintervall oder Entladestromintervall und/oder einem Temperaturintervall und/oder einem Ladezustandsintervall und/oder einem Ruhezeitintervall um einen jeweiligen Referenzparameter sein kann.

Beispielsweise kann das Temperaturintervall ±5 Kelvin um eine Referenztemperatur und/oder das Ladezustandsintervall kann ± 20% um einen Referenzladezustand betragen. Alternativ kann ein erstes Ladezustandsintervall im Bereich von 0 bis 20 %, ein zweites von 20 bis 40 %, ein drittes von 60 bis 80 % sein. Ebenfalls kann beispielsweise ein erstes Temperaturintervall im Bereich von 0°C bis 5°C, ein zweites von 5°C bis 10°C sein, wobei die folgenden Temperaturintervalle entsprechend fortgeführt werden.

Das Ruhezeitintervall kann beispielsweise zumindest drei Viertel einer Relaxationszeit, beispielsweise die gesamte Relaxationszeit, bis zu einem Vielfachen der Relaxationszeit betragen. Die Ruhezeit kann eine Zeit einer Inaktivität der Batterie, insbesondere zumindest teilweise eine Relaxationszeit der Batterie sein. Beispielsweise kann die Ruhezeit zwischen einem Ruhezeitbeginn und der Ladestartzeit sein. Der Ruhezeitbeginn kann beispielsweise mittels einer Auswertung von Signalen aus einem Datenbussystem eines Kraftfahrzeugs zur Geschwindigkeit des Kraftfahrzeugs und/oder zu einem Betriebszustand einer Schließanlage und/oder einer Heizung (Standheizung oder Fahrgastzellenheizung) des Kraftfahrzeugs und/oder mittels einer Messung eines Vorhandenseins eines Aufladestroms oder Entladestroms bestimmt werden, beispielsweise von einem Batteriesteuergerät. Normalerweise wird die Relaxation der Batterie durch den Batteriestrom bestimmt, was das Batteriesteuergerät der Batterie üblicherweise messen kann. Wenn der Batteriestrom null oder sehr klein ist, kann die Batterie anfangen, zu relaxieren. Beispielsweise kann die Ruhezeit zumindest teilweise die Relaxationszeit betragen. Insbesondere kann der Ruhezeitbeginn als der Zeitpunkt bestimmt werden, an welchem die Geschwindigkeit des Kraftfahrzeugs null ist und an welchem ein Messwert des Aufladestroms oder Entladestroms null ist.

Ergänzend oder alternativ kann ein Signal von der Ladevorrichtung empfangen werden, welches anzeigt, dass das Kraftfahrzeug mit der Ladevorrichtung elektrisch verbunden ist und der Zeitpunkt des Empfangs des besagten Signals kann dann als Ruhezeitbeginn bestimmt werden. Wenn das Kraftfahrzeug physikalisch mit der Ladevorrichtung verbunden ist, kann es nicht fahren und der Antrieb kann somit keinen Strom von dem Batteriesystem beziehen. Beispielsweise kann der Zeitpunkt eines Detektierens eines ersten Signals über einen Kontakt eines Control Pilots (CP) und/oder eines Proximity Pilots (PP), welche jeweils eine Verbindung mit einem Ladestecker einer Ladevorrichtung anzeigen, als Ruhezeitbeginn bestimmt werden. Das Laden kann nach Ablauf der Ruhezeit starten. Zudem kann zumindest ein Schaltelement einer Schaltanordnung zum elektrischen Trennen der jeweiligen Gruppen von einem Batterieanschluss während der Ruhezeit angesteuert werden, damit die jeweilige Gruppe entspannen kann, wenn sie elektrisch getrennt ist. Hierdurch ergibt sich der Vorteil, dass der Datensatz und damit ein Speicherbedarf reduziert werden kann.

Die Umweltbedingung des Ladevorgangs kann dieselbe Umweltbedingung aus dem vorhergehenden Ladevorgang sein, wenn der jeweilige Parameter der Umweltbedingung einen gleichen Wert hat wie der jeweilige Parameter der Umweltbedingung aus dem vorhergehenden Ladevorgang und/oder wenn der jeweilige Parameter der Umweltbedingung sich innerhalb eines Toleranzintervalls um einen Referenzwert des jeweiligen Parameters der Umweltbedingung aus dem vorhergehenden Ladevorgang befindet, wobei der Referenzwert des jeweiligen Toleranzintervalls dem Wert des jeweiligen Parameters der Umweltbedingung aus dem vorhergehenden Ladevorgang entspricht. Mit anderen Worten, die Umweltbedingung des aktuellen Ladevorgangs und die Umweltbedingung des vorherigen Ladevorgangs können dieselbe Umweltbedingung sein, wenn die jeweiligen Parameter aus dem aktuellen Ladevorgang und dem vorherigen Ladevorgang sich innerhalb eines Toleranzintervalls um den jeweiligen Parameter des vorherigen Ladevorgangs befinden. Beispielsweise kann die Ruhezeit vor dem aktuellen Ladevorgang in einem Toleranzintervall um die Ruhezeit der Batterie vor dem vorherigen Ladevorgang Referenzwert liegen.

Ein Parameterintervall für die Temperatur und dem Ladezustand und die Ruhezeit der Batterie vor dem Ladevorgang kann verwendet werden, welches jeweils eine Toleranzgrenze des jeweiligen Parameters bestimmt. Unter dem jeweiligen Parameter der Umweltbedingung können der Spannungszustand der Klemmenspannung und/oder den Widerstand in dem Speicher gespeichert werden. Hierdurch ergibt sich der Vorteil, dass der Datensatz und damit ein Speicherbedarf weiter reduziert werden kann. Außerdem kann ein Intervall zwischen dem aktuellen und vorherigen Ladevorgang, zu welchen die Schätzung des defekten Anteils der Batteriezellen durchgeführt wird, reduziert werden.

Die Ruhezeit kann aus einer Zeit einer Inaktivität der Batterie und/oder aus einer Differenz einer Zeit zwischen dem Ruhezeitbeginn und einer Ladestartzeit t und/oder nach einer Relaxationszeit der Batterie bestimmt werden. Die Ladestartzeit kann der Zeitpunkt sein, an welchem der Ladestrom oder Entladestrom von Null verschieden sind und/oder einen Stromschwellenwert überschreiten. Der Ruhezeitbeginn kann der Zeitpunkt sein, an welchem das Kraftfahrzeug an die Ladevorrichtung angeschlossen wird. Insbesondere kann zu einem Ladeziel der Batterie, beispielsweise ein Ladezustand von 80 Prozent, von einem Benutzer eine Ladezielzeit vorgegeben werden, zu welcher das Ladeziel erreicht sein sollte. In Abhängigkeit von dem Ladeziel und der Ladezielzeit und dem Aufladestrom kann die Ladestartzeit für den Beginn eines Ladevorgangs derart bestimmt werden, dass das Ladeziel zur Ladezielzeit erreicht werden kann. Dabei kann ergänzend die Ruhezeit zwischen dem Ruhezeitbeginn und der Ladestartzeit derart bestimmt werden, dass die Ruhezeit zumindest teilweise die Relaxationszeit der Batterie, beispielsweise zumindest drei Viertel der Relaxationszeit beträgt.

Mit anderen Worten, die Ruhezeit kann eine Zeit einer Inaktivität der Batterie, insbesondere zumindest teilweise eine Relaxationszeit der Batterie sein. Die Ruhezeit kann hierzu zwischen einem Ruhezeitbeginn und der Ladestartzeit liegen. Der Ruhezeitbeginn kann mittels einer Auswertung von Signalen aus einem Datenbussystem eines Kraftfahrzeugs zur Geschwindigkeit des Kraftfahrzeugs und/oder zu einem Betriebszustand einer Schließanlage des Kraftfahrzeugs und/oder mittels einer Messung eines Zeitverlaufs des Aufladestroms oder Entladestroms bestimmt werden. Insbesondere kann der Ruhezeitbeginn als der Zeitpunkt bestimmt werden, an welchem die Geschwindigkeit des Kraftfahrzeugs null ist und an welchem der Aufladestrom oder Entladestrom Null sind. Der Spannungszustand der Klemmenspannung kann dann bestimmt werden, wenn die Ruhezeit zumindest teilweise die Relaxationszeit beträgt, wie beispielsweise mindestens drei Vierteil der Relaxationszeit. Das Batteriesteuergerät kann den Spannungszustand der Klemmenspannung bestimmen, wenn die Ruhezeit zumindest die Relaxationszeit beträgt.

Ergänzend oder alternativ kann ein Signal von der Ladevorrichtung empfangen werden, dass das Kraftfahrzeug mit der Ladevorrichtung elektrisch verbunden ist und der Zeitpunkt des Empfangs des besagten Signals als den Ruhezeitbeginn bestimmt werden. Der Ruhezeitbeginn kann somit mit dem Anschließen des Kraftfahrzeugs an die Ladevorrichtung beginnen. Die Ruhezeit kann daher die Zeit zwischen dem Ruhezeitbeginn und der Ladestartzeit sein. Die Ladestartzeit kann derart berechnet werden, dass ein mittels einer Benutzereingabe empfangenes Ladeziel stets erreicht wird. Das Ladeziel kann dabei einen Ladesollzustand der Batterie nach dem Ladevorgang sein, beispielsweise eine Ladezielzeit wie beispielsweise um 06:00 Uhr morgens, sein.

Hierdurch ergibt sich der Vorteil, dass eine Verfälschung der Schätzung des Anteils der defekten Batteriezellen in der Gruppe durch eine Hysterese der Batterie beim Laden und Entladen vermieden werden kann. Insbesondere kann das Schätzverfahren von einem Benutzer unbemerkt durchgeführt werden.

Die oben gestellte Aufgabe wird weiterhin durch ein Batteriesteuergerät, insbesondere ein Batteriemanagementsystem, mit den Merkmalen des Anspruchs 11 gelöst.

Das Batteriesteuergerät, insbesondere das Batteriemanagementsystem, ist dazu eingerichtet, einen Anteil defekter Batteriezellen einer Gruppe elektrisch parallel geschalteter Batteriezellen in einer Batterie zu bestimmen, wobei das Batteriesteuergerät eine Prozessoreinheit aufweist, welche dazu eingerichtet ist, mittels einer Messeinrichtung einen Spannungszustand einer Klemmenspannung der Gruppe in Bezug auf einen Ladevorgang und/oder in Bezug auf eine Relaxation der Batterie unter einer Umweltbedingung zu bestimmen und eine Abweichung und eine Veränderungsrate der Abweichung des mittels der Messeinrichtung bestimmten Spannungszustands der Klemmenspannung einerseits von dem in einem Speicher gespeicherten Spannungszustand der Klemmenspannung derselben Gruppe aus einem vorherigen Ladevorgang und/oder einer vorherigen Relaxation unter derselben Umweltbedingung und/oder andererseits von dem im Speicher gespeicherten Spannungszustand der Klemmenspannung von zumindest einer anderen Gruppe der Batterie und/oder von einem Durchschnittswert des Spannungszustands der jeweiligen Klemmenspannung von zumindest zwei Gruppen der Batterie zu berechnen, wobei die Prozessoreinheit dazu eingerichtet ist, aus der berechneten Abweichung und aus der Veränderungsrate der Abweichung den Anteil der defekten Batteriezellen in der Gruppe zu bestimmen.

Mittels eines Vergleichs der Abweichung mit einem gespeicherten Abweichungsschwellenwert kann der Anteil der defekten Batteriezellen in der Gruppe bestimmt werden.

Mit anderen Worten, das Batteriesteuergerät kann eine Prozessoreinheit umfassen, die so angepasst ist, dass sie das oben besagte Verfahren ausführt.

Dazu kann das Batteriesteuergerät dazu eingerichtet sein, mit der Messeinrichtung, insbesondere zur Spannungsmessung der Klemmenspannung der Gruppe, mittels einer Signalleitung verbunden zu werden. Das Batteriesteuergerät kann dazu ausgebildet sein, mittels der Signalleitung zumindest ein Schaltelement einer Schaltanordnung der Batterie für ein Öffnen und/oder ein Schließen anzusteuern. Mittels der Schaltelemente in der Schaltanordnung kann eine Gruppe, deren Anteil defekter Batteriezellen einen Anteilsschwellenwert überschreitet, von der Batterie und/oder den anderen Gruppen der Batterie elektrisch getrennt werden.

Das Batteriesteuergerät kann dazu eingerichtet sein, bei einem Überschreiten der Abweichung über einen Abweichungsschellenwert das Schaltelement der Schaltanordnung derart anzusteuern, dass die Gruppe elektrisch getrennt und/oder ein Ladestrom, beispielsweise mittels eines Vorladewiderstands, begrenzt und/oder eine Warnmeldung ausgegeben wird. Die Warnmeldung kann beispielsweise eine Aufforderung an einen Benutzer umfassen, eine Werkstatt für einen Austausch der Gruppe des Batteriesystems aufzusuchen. Dafür kann das Batteriesteuergerät dazu eingerichtet sein, ein Signal für ein Aktivieren eines Notbetriebs der Batterie auszugeben, in welchem der Entladestrom begrenzt ist. Ergänzend kann das Batteriesteuergerät dazu eingerichtet sein, die Warnmeldung als einen Hinweis an eine Werkstatt für einen Austausch der betroffenen Gruppe auszugeben. Der Anteilsschwellenwert kann beispielsweise 50 Prozent sein. Mit anderen Worten, wenn beispielsweise das Batteriesteuergerät bestimmt, dass die Hälfte der Batteriezellen in der Gruppe defekt ist, kann das Batteriesteuergerät mittels eines Ansteuerns der jeweiligen Schaltelemente die Gruppe elektrisch trennen und/oder einen Aufladestrom oder einen Entladestrom mittels eines Vorladewiderstands begrenzen und/oder eine Warnmeldung ausgeben.

Ergänzend kann das Batteriesteuergerät dazu ausgebildet sein, eine Veränderungsrate der Abweichung mittels eines Vergleichs der berechneten Abweichung in Bezug auf einen aktuellen Ladevorgang mit der berechneten Abweichung aus zumindest einem vorherigen Ladevorgang, insbesondere in Bezug auf einen Referenzwert aus einem vorherigen Ladevorgang, zu bestimmen. Beispielsweise kann das Batteriesteuergerät dazu ausgebildet sein, die berechnete Abweichung aus dem vorherigen Ladevorgang jeweils als Referenzwert für die Bestimmung der Veränderungsrate zu verwenden. Wenn beispielsweise die Veränderungsrate einen Schwellenwert in Bezug zum Referenzwert überschreitet, insbesondere wenn ein Sprung in der Veränderungsrate detektiert wird, kann das Batteriesteuergerät dazu ausgebildet sein, zu bestimmen, dass ein Tausch von einer alten Gruppe mit einer neuen Gruppe stattgefunden hat. Für diesen Fall kann das Batteriesteuergerät dazu ausgebildet sein, die berechnete Abweichung als einen neuen Referenzwert in einem Speicher zu speichern und ergänzend ein Signal auszugeben, die jeweilige Gruppe bei einem Überschreiten der Veränderungsrate über den besagten Schwellenwert nicht zu diskonnektieren. Wenn die Veränderungsrate den Schwellenwert unterschreitet, insbesondere kein Sprung in der Veränderungsrate detektiert wird, kann das Batteriesteuergerät dazu ausgebildet sein, zu bestimmen, dass die berechnete Abweichung in Bezug auf den Ladevorgang durch eine Alterung der Batteriezellen in der Gruppe und/oder durch Fertigungstoleranzen bewirkt ist.

Das Batteriesteuergerät und insbesondere das Batteriemanagementsystem können hierzu jeweils als eine elektronische Steuereinheit (ECU) vorgesehen sein, welche zumindest einen Prozessor und/oder zumindest einen Speicher umfasst, wobei in dem Speicher Programmanweisungen gespeichert sind, die den zumindest einen Prozessor dazu veranlassen, das besagte Verfahren auszuführen. Mit anderen Worten, das Batteriesteuergerät und insbesondere das Batteriemanagementsystem können jeweils eine Datenverarbeitungsvorrichtung oder zumindest eine Prozessoreinrichtung aufweisen, die dazu eingerichtet ist, das oben beschriebene Verfahren durchzuführen. Die Prozessoreinrichtung kann hierzu zumindest einen Mikroprozessor und/oder zumindest einen Mikrocontroller und/oder zumindest einen FPGA (Field Programmable Gate Array) und/oder zumindest einen DSP (Digital Signal Processor) aufweisen. Des Weiteren kann die Prozessoreinrichtung Programmcode aufweisen, der dazu eingerichtet ist, bei Ausführen durch die Prozessoreinrichtung die Ausführungsform des besagten Verfahrens durchzuführen. Der Programmcode kann in einem Datenspeicher oder Prozessoreinrichtung gespeichert sein.

Ergänzend oder alternativ können das Batteriesteuergerät und insbesondere das Batteriemanagementsystem mit dem Speicher mittels einer drahtgebundenen und/oder einer drahtlosen Datenleitung verbunden sein, in welchem die Daten der Zeitverläufe der Klemmenspannung und/oder des elektrischen Widerstands gespeichert sind. Ergänzend können der Abweichungsschwellenwert und/oder der Anteilsschwellenwert in dem Speicher oder in einem anderen Speicher gespeichert sein. Das Batteriesteuergerät und insbesondere das Batteriemanagementsystem können den Speicher aufweisen.

Ergänzend kann das Batteriesteuergerät dazu ausgebildet sein, den Spannungszustand der Messwerte zur Klemmenspannung und/der des Widerstands mittels eines Filterelements zu logarithmieren. Hierdurch ergibt sich der Vorteil, dass die jeweilige Abweichung durch Prozessoreinrichtung, insbesondere einem Mikrocontroller, effizienter berechnet werden kann.

Die oben gestellte Aufgabe wird weiterhin durch ein Computerprogramm mit den Merkmalen des Anspruchs 12 gelöst, welches Befehle umfasst, die bei der Ausführung des Programmes durch das Batteriesteuergerät, insbesondere das Batteriemanagementsystem, dieses Veranlassen, das oben beschriebene Verfahren durchzuführen.

Mit anderen Worten, das Computerprogramm kann vorzugsweise für eine Anwendung für eingebettete Systeme implementiert sein. Zusätzlich kann das Computerprogramm für eine Ausführung mittels eines Mikrocontrollers ausgebildet sein, wobei der Spannungszustand der Klemmenspannung logarithmiert wird.

Zudem sieht die Erfindung ein computerlesbares Speichermedium mit den Merkmalen des Anspruchs 13 vor, auf welchem das besagte Computerprogramm gespeichert ist.

Mit anderen Worten, das computerlesbare Speichermedium kann eine Lochkarte, ein (Disketten-) Speichermedium, eine Festplatte, eine CD, eine DVD, ein USB (Universal Serial Bus)-Speichergerät, ein RAM (Random Access Memory), ein ROM (Read Only Memory) und/oder ein EPROM (Erasable Programmable Read Only Memory) sein. Vorzugsweise kann das computerlesbare Speichermedium ein RAM oder ein ROM sein, wobei insbesondere ein Flash-Speicher verwendet wird. Bei dem computerlesbaren Speichermedium kann es sich auch um ein Datenkommunikationsnetz handeln, das das Herunterladen eines Programmcodes ermöglicht, wie z.B. das Internet, oder um weitere Systeme. Das Batteriesteuergerät, insbesondere das Batteriemanagementsystem, können jeweils das computerlesbare Speichermedium umfassen.

Weiterhin sieht die Erfindung auch eine Batterie mit den Merkmalen des Anspruchs 14 vor, wobei die Batterie insbesondere für ein Kraftfahrzeug ausgebildet ist. Die Batterie umfasst das besagte Batteriesteuergerät. Die Batterie kann beispielsweise eine Lithium-Ionen-Batterie sein. Zudem kann die Batterie als ein verteiltes Batteriesystem ausgebildet sein.

Die Erfindung sieht auch ein Kraftfahrzeug mit den Merkmalen des Anspruchs 15 vor, welches die besagte Batterie und/oder das besagte Batteriesteuergerät umfasst.

Das Kraftfahrzeug ist beispielsweise als Kraftwagen, insbesondere als Personenkraftwagen oder Lastkraftwagen, oder als Personenbus oder Motorrad ausgestaltet. Das Kraftfahrzeug kann elektrisch angetrieben (EV) oder insbesondere ein Hybridelektrofahrzeug (HEV, PHEV) sein.

Die Erfindung umfasst auch Realisierungen, die eine Kombination der Merkmale mehrerer der beschriebenen Ausführungsformen umfassen.

### Kurze Beschreibung der Figuren

Bevorzugte weitere Ausführungsformen der Erfindung werden durch die nachfolgende Beschreibung der Figuren näher erläutert. Dabei zeigen:
- Figur 1: eine schematische Darstellung einer Batterie in einem Kraftfahrzeug, welche zumindest eine Gruppe von Batteriezellen aufweist, welche jeweils eine Anzahl von elektrisch parallel geschalteten Batteriezellen umfasst;
- Figur 2: eine schematische Darstellung eines Entlade- und Ladevorgangs einer Gruppe der Batterie in zwei unterschiedlichen Betriebszuständen zu unterschiedlichen Zeitpunkten; und
- Figur 3: eine schematische Darstellung eines Verfahrens zum Ermitteln des Anteils der defekten Batteriezellen in einer Gruppe für ein Batteriesteuergerät.

### Detaillierte Beschreibung bevorzugter Ausführungsbeispiele

Im Folgenden werden bevorzugte Ausführungsbeispiele anhand der Figuren beschrieben. Dabei werden gleiche, ähnliche oder gleichwirkende Elemente in den unterschiedlichen Figuren mit identischen Bezugszeichen versehen, und auf eine wiederholte Beschreibung dieser Elemente wird teilweise verzichtet, um Redundanzen zu vermeiden.

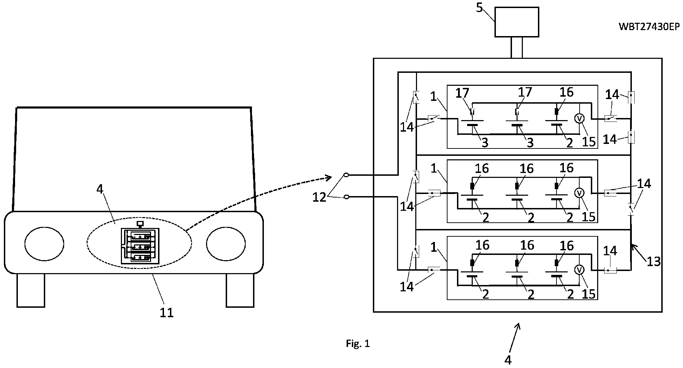

In Figur 1 ist links schematisch ein Kraftfahrzeug 11 dargestellt, welches eine Batterie 4 umfasst. Die Batterie 4 rechts in Figur 1 weist zumindest eine Gruppe 1 auf, welche eine Anzahl von elektrisch parallel geschalteten Batteriezellen 2 und 3 umfasst. Die Gruppen 1 sind mittels der Schaltanordnung 13 jeweils elektrisch in einer Reihen- oder in einer Parallelschaltung miteinander verbunden, insbesondere mit dem Batterieanschluss 12, über welchen ein Lade- und/oder ein Entladevorgang der Batterie 4 erfolgt. Mittels der Schaltelemente 14 der Schaltanordnung 13 kann jeweils eine Gruppe 1 von der Schaltanordnung 13 elektrisch getrennt und/oder mit dieser verbunden werden. Insbesondere kann dazu das jeweilige Schaltelement 14 von dem Batteriesteuergerät 5 für ein Öffnen und/oder ein Schließen einer elektrischen Verbindung angesteuert werden. Das Batteriesteuergerät 5 kann hierzu beispielsweise als ein Batteriemanagementsystem ausgebildet sein.

Die jeweilige Gruppe 1 weist eine Messeinrichtung 15 auf, welche dazu ausgebildet ist, eine Klemmenspannung U der jeweiligen Gruppe 1 zu messen. Durch die Parallelschaltung der Batteriezellen 2 und 3 in der Gruppe 1 teilen die Batteriezellen 2 und 3 in der Regel dasselbe Spannungsniveau. Das Batteriesteuergerät 5 ist dazu ausgebildet, einen Ladevorgang, insbesondere eine Ladestartzeit *tₗ*, ein Ladeziel *Uₕ* und/oder eine Ladezeit der Batterie 4 zu steuern. Das Ladeziel *Uₕ* kann dabei ein Zielladezustand der Batterie 4 sein, welcher von einem Benutzer vorgegeben werden kann, wie beispielsweise einen Ladestand von 60, 70 oder 80 Prozent, zu welchem die Gruppe jeweils eine Klemmenspannung *Uₕ* aufweist.

Die Ladezeit kann eine von dem Batteriesteuergerät 5 prognostizierte Zeit sein, die die Batterie 4 unter einer Vorgabe eines Aufladestroms der Ladevorrichtung zum Erreichen des Ladeziels *Uₕ* benötigt. Insbesondere kann zu dem Ladeziel *Uₕ* von einem Benutzer eine Ladezielzeit *tₕ* vorgegeben werden, zu welcher das Ladeziel *Uₕ* erreicht sein sollte. In Abhängigkeit von dem Ladeziel *Uₕ* und der Ladezielzeit *tₕ* und dem Aufladestrom kann das Batteriesteuergerät 5 dazu ausgebildet sein, die Ladestartzeit *tₗ* für den Beginn eines Ladevorgangs derart zu bestimmen, dass das Ladeziel *Uₕ* zur Ladezielzeit *tₕ* erreicht werden kann.

Zur Bestimmung eines Gesundheitszustands der Batterie 4 ist das Batteriesteuergerät 5 ergänzend dazu ausgebildet, Messdaten von der jeweiligen Messeinrichtung 15 einer Gruppe 1 über eine drahtgebundene und/oder drahtlose Datenverbindung zu empfangen und in einem Speicher zu speichern. Ergänzend ist das Batteriesteuergerät 5 dazu ausgebildet, eine Abweichung eines aktuellen Spannungszustands *t*₁*,t*₂ und *t*₃ des Messwerts zur Klemmenspannung *U_{c}* der jeweiligen Gruppe 1 während eines aktuellen Ladevorgangs von dem Spannungszustand *t*₁*, t*₂ und *t*₃ des Messwerts der Klemmenspannung *Uₚ* derselben Gruppe 1 aus einem vorherigen Ladevorgang unter derselben oder einer ähnlichen Umweltbedingung zu bestimmen.

Ergänzend oder alternativ kann das Batteriesteuergerät 5 dazu ausgebildet sein, die Abweichung des Spannungszustands *t*₁*, t*₂ und *t*₃ des Messwerts zur Klemmenspannung *U_{c}* der jeweiligen Gruppe 1 während des aktuellen Ladevorgangs von dem Spannungszustand des Messwerts der Klemmenspannung *Uₚ* einer anderen Gruppe 1, insbesondere eine Abweichung der aktuellen Klemmenspannung von einem Referenzwert, zu bestimmen. Der Referenzwert kann beispielsweise ein Durchschnittswert der Zeitverläufe der *t*₁*, t*₂ und *t*₃ des Messwerts zur Klemmenspannung *Uₚ* der anderen Gruppen in der Batterie, insbesondere während des aktuellen Ladevorgangs, sein.

Der Gesundheitszustand der Batterie 4 kann ein Anteil von defekten Batteriezellen 17 an der Gesamtzahl von Batteriezellen 16 in der jeweiligen Gruppe 1 umfassen. Die jeweilige Gruppe 1 kann gesunde Batteriezellen 2 und defekte Batteriezellen 3 umfassen. Gesunde Batteriezellen 2 können über die Zeit und/oder durch Umwelteinflüsse, wie beispielsweise Herstellungsfehler, in unterschiedlichen Geschwindigkeiten altern. Dadurch können gesunde Batteriezellen 2 vorzeitig zu defekten Batteriezellen 3 werden, welche einen erhöhten inneren elektrischen Widerstand *R* und eine geringere Klemmenspannung *U* aufweisen als gesunde Batteriezellen 2 in der Gruppe 1. Eine defekte Batteriezelle 3 in der Gruppe 1 kann bei einem Lade- und/oder einem Entladevorgang der Batterie 4 zu einer erhöhten Wärmeentwicklung führen und unerwünschte Ausgleichsströme verursachen. Somit können die defekten Batteriezellen 3 die gesunden Batteriezellen 2 in der Batterie 4 schaden.

Zum Begrenzen des Schadens an den gesunden Batteriezellen 2 durch die defekten Batteriezellen 3, weisen die jeweiligen Batteriezellen 2 und 3 einen Batteriezelltrennschalter 16 und 17 auf, wobei die gesunden Batteriezellen 2 einen elektrisch geschlossenen Batteriezelltrennschalter 16 und die defekten Batteriezellen 3 einen elektrisch geöffneten Batteriezelltrennschalter 17 für ein elektrisches Trennen der defekten Batteriezelle 3 von den gesunden Batteriezellen 2 in der Gruppe 1 aufweisen. Die Batteriezelltrennschalter 16 und 17 sind jedoch häufig als eine elektrische Sicherung als letztes Mittel zur Schadensabwehr ausgelegt, die dann aktiviert wird, wenn ein Schwellenwert, wie beispielsweise eine Temperatur der Batteriezelle 2 und 3, überschritten wird. Aus diesem Grund weisen Batterien 4 keine Sensoranordnung auf, sodass ein Öffnen oder Schließen des jeweiligen Batteriezelltrennschalters 16 und 17 von dem Batteriesteuergerät 5 ausgelesen werden kann, sodass die Zahl der defekten Batteriezellen 3 dem Batteriesteuergerät 5 unbekannt ist. Zudem kann die Grenze zwischen einer gesunden Batteriezelle 2 und einer defekten Batteriezelle 3 unscharf sein.

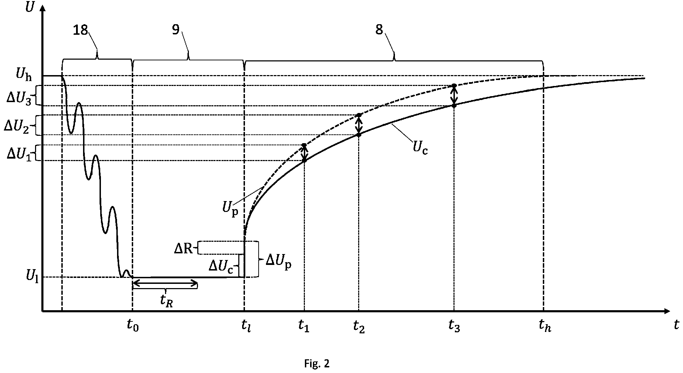

Für eine Prognose des Gesundheitszustands der Batterie 4 durch das Batteriesteuergerät 5 ist es deshalb vorteilhaft, den Anteil der defekten Batteriezellen 3, insbesondere des Anteils der elektrisch getrennten oder defekten Batteriezellen 3, in der jeweiligen Gruppe durch das Batteriesteuergerät 5 anhand einer Ladecharakteristik zu schätzen. Das Schätzen des Anteils der defekten Batteriezellen 3 mittels der Ladecharakteristik bei einem Ladevorgang wird in Figur 2 gezeigt.

Figur 2 zeigt eine schematische Darstellung des Spannungszustands *t*₁*, t*₂ und *t*₃ des Messwerts zur Klemmenspannung *U_{c}* der Gruppe 1 während eines Entladevorgangs 18, während der Ruhezeit 9 sowie während eines Ladevorgangs 8 der Batterie 4. Zum Vergleich zeigt Figur 2 ergänzend den Spannungszustand *t*₁*, t*₂ und *t*₃ des Messwerts von einer beispielhaften Klemmenspannung *Uₚ* derselben Gruppe 1 aus einem vorhergegangenen Ladevorgang 8 unter derselben Umweltbedingung oder einer anderen Gruppe 1 aus demselben Ladevorgang 8 oder aus dem vorhergegangen Ladevorgang 8 unter derselben Umweltbedingung.

Die Batterie 4 hat am Anfang einen Ladezustand, bei welchem die Gruppe die Klemmenspannung *Uₕ* aufweist. Die Batterie 4 im Kraftfahrzeug 11 wird nun im Folgenden entladen. Während des Entladevorgangs 18 benötigt das Kraftfahrzeug 4 elektrische Energie von der Batterie 4, welche über den Batterieanschluss 12 von der Batterie 4 an das Kraftfahrzeug 11 abgegeben wird. Während des Entladevorgangs 18 sinkt daher die Klemmenspannung *U* der Gruppe 1. Dabei können kurzfristige Schwankungen einer Entladegeschwindigkeit beispielsweise durch ein Beschleunigen und/oder ein Rekuperieren des Kraftfahrzeugs 11 auftreten.

Wenn die Batterie 4 ausreichend entladen worden ist, weist die Batterie 4 einen zweiten, niedrigen Ladezustand *Uₗ* auf, bei welchem die Gruppe 1 die Klemmenspannung *Uₗ* aufweist. Zum Zeitpunkt des Ruhezeitbeginns *t*₀ wird das Kraftfahrzeug 11 zum Laden an eine Ladevorrichtung, wie beispielsweise einer Wallbox, für einen Aufladen der Batterie 4 angeschlossen. Der Ladevorgang 8 beginnt zur Ladestartzeit *tₗ* und endet, wenn das Ladeziel *Uₕ* bei der Klemmenspannung *Uₕ* zur Ladezielzeit *tₕ* erreicht ist.

Nach Ablauf der Ruhezeit 9 beginnt der Ladevorgang 8 zur Ladestartzeit *tₗ*, wobei die Batterie 4 über den Batterieanschluss 12 während des Ladevorgangs 8 zumindest teilweise mit einem konstanten Aufladestrom geladen wird. Dabei kann die Ruhezeit 9 zumindest teilweise eine Relaxationszeit *t_{R}* der Batterie 4 betragen, beispielsweise zumindest die Relaxationszeit *t_{R}*. Das Batteriesteuergerät 5 kann beispielsweise die Ladestartzeit *tₗ* derart bestimmen, dass das Ladeziel *Uₕ* zur Ladezielzeit *tₕ* erreicht wird. Zudem kann das Batteriesteuergerät 5 den Ruhezeitbeginn *t*₀ erkennen, wenn das Kraftfahrzeug 11 mit einer Ladevorrichtung verbunden wird. Beispielsweise kann der Ladevorgang 8 starten, wenn zumindest teilweise die Relaxationszeit *t_{R}* als Ruhezeit 9 abgelaufen ist, wie beispielsweise drei Viertel der Relaxationszeit *t_{R}* der Batterie 4 als Mindestbedingung.

Das Batteriesteuergerät 5 kann dabei den Anstieg der Klemmenspannung *U_{c}* der Gruppe 1 während des Ladevorgangs 8 mittels der Messeinrichtung 15 zu den Zeitpunkten *t*₁*, t*₂ und *t*₃ messen und den Spannungszustand *t*₁*, t*₂ und *t*₃ der Messwerte ergänzend in einem Speicher speichern.

Beispielsweise kann das Batteriesteuergerät 5 während des Ladevorgangs 8 die Klemmenspannung *U_{c}* in regelmäßigen Zeitabständen mittels der Messeinrichtung 15 messen. Ergänzend oder alternativ kann das Batteriesteuergerät 5 eine Mindestanzahl an Messpunkten während einer Anlaufphase, insbesondere einer Konstantstromphase, des Ladevorgangs 8 haben, an denen das Batteriesteuergerät 5 eine Spannungsmessung an der Gruppe 1 mittels der Messeinrichtung 15 durchführt. Dabei kann das Batteriesteuergerät 5 beginnen, den Spannungszustand der Klemmenspannung *U_{c}* aufzuzeichnen, sobald der Aufladestrom ab der Ladestartzeit *tₗ* in einer ersten Hälfte der Ladezeit des Ladevorgangs 8 konstant bleibt.

Das Batteriesteuergerät 5 bestimmt den Spannungszustand der Klemmenspannung *U_{c}* unter zumindest einer Umweltbedingung. Die Umweltbedingung kann als Parameter einen Aufladestrom oder Entladestrom und/oder eine Temperatur und/oder einen Ladezustand *Uₗ* der Batterie 4 und/oder die Ruhezeit 9 der Batterie 4 umfassen.

Das Batteriesteuergerät 5 kann die Parameter des Ladezustands *Uₗ* und der Temperatur und die Ruhezeit der Batterie 4 als Umweltbedingung verwenden, unter welchen der Spannungszustand der Klemmenspannung *U_{c}* in dem Speicher gespeichert wird.

Ergänzend oder alternativ kann das Batteriesteuergerät 5 für die Umweltbedingung ein Parameterintervall verwenden, insbesondere ein Aufladestromintervall oder Entladestromintervall und/oder ein Temperaturintervall und/oder ein Ladezustandsintervall und/oder ein Ruhezeitintervall. Hierdurch können ein Datensatz für das Speichern des Spannungszustands der Klemmenspannung *U_{c}* unter der Umweltbedingung und somit ein Speicherbedarf des Batteriesteuergeräts 5 reduziert werden. Das Ruhezeitintervall kann beispielsweise mindestens drei Viertel der Relaxationszeit *t_{R}* bis zu einem Vielfachen der Relaxationszeit *t_{R}* betragen. Wenn jeweils ein von dem Batteriesteuergerät 5 empfangener Parameter der Umweltbedingung aus dem aktuellen Ladevorgang 8 in das jeweilige Parameterintervall der Umweltbedingung aus dem vergangenen Ladevorgang 8 fällt, kann das Batteriesteuergerät 5 bestimmen, dass dieselbe Umweltbedingung vorliegt.

Eine Abweichung Δ*U*₁*,* Δ*U*₂ und Δ*U*₃ des Spannungszustands *t*₁*, t*₂ und *t*₃ der Klemmenspannung *U_{c}* der Gruppe 1 während des Ladevorgangs 8 wird von dem Batteriesteuergerät 5 von einem Spannungszustand *t*₁*, t*₂ und *t*₃ der Klemmenspannung *Uₚ* derselben Gruppe 1 aus einen vorherigen Ladevorgang 8 unter derselben Umweltbedingung, beispielsweise unter demselben Temperaturintervall und/oder Ladezustandsintervall und/oder demselben Ruhezeitintervall, berechnet.

Beispielsweise kann das Batteriesteuergerät zu jedem Abtastpunkt der Messung eine Differenz zwischen der Klemmenspannung *U_{c}* und der Klemmenspannung *Uₚ* bilden und den Betrag der jeweiligen Differenzen aufsummieren. Die Abweichung mittels des Spannungszustands der Klemmenspannung *Uₚ* ist hierzu bereits in dem Speicher gespeichert.

Ergänzend oder alternativ kann das Batteriesteuergerät 5 eine Abweichung Δ*U*₁*,* Δ*U*₂ und Δ*U*₃ des Spannungszustands *t*₁, *t*₂ und *t*₃ der Klemmenspannung *U*_{c} von einem Spannungszustand *t*₁, *t*₂ und *t*₃ der Klemmenspannung *Uₚ* einer anderen Gruppe 1 aus demselben Ladevorgang 8 oder aus einem vorherigen Ladevorgang 8 unter derselben Umweltbedingung berechnen.

Ergänzend oder alternativ kann das Batteriesteuergerät 5 einen elektrischen Widerstand *R*₁ der Gruppe während des Ladevorgangs 8 beispielsweise zur Ladestartzeit *tₗ* aus der Klemmenspannung *U_{c}* und dem Aufladestrom bestimmen. Zudem kann das Batteriesteuergerät 5 eine Abweichung des Widerstands *R*₁ von einem Widerstand *R*₂ von derselben Gruppe 1 aus einem vorherigen Ladevorgang 8 und/oder von dem Widerstand *R*₂ von einer anderen Gruppe 1 aus demselben Ladevorgang 8 oder aus einem vorherigen Ladevorgang 8 unter derselben Umweltbedingung berechnen. Der Widerstand *R*₂ ist hierzu in dem Speicher des Batteriesteuergeräts unter der Umweltbedingung gespeichert. Das Batteriesteuergerät 5 kann die Abweichung des Widerstands Δ*R* aus einer Differenz der Klemmenspannung *U_{c}* und der Klemmenspannung *Uₚ* derselben Gruppe 1 aus dem aktuellen Ladevorgang 8 und/oder einer anderen, baugleichen Gruppe 1 aus dem aktuellen Ladevorgang 8 oder einem vorherigen Ladevorgang 8 unter derselben Umweltbedingung zu Beginn des Ladvorgangs 8, beispielsweise zur Ladestartzeit *tₗ*, bestimmen. Insbesondere können zur Ladestartzeit *tₗ* die Klemmenspannungen *U_{c}* und *Uₚ* jeweils sprunghaft ansteigen, wobei aus der Differenz der Spannungssprünge *U_{c} - Uₚ* das Batteriesteuergerät 5 die Widerstandsveränderung Δ*R* bestimmen kann.

Bei einem Überschreiten der Abweichung Δ*U*₁*,* Δ*U*₂ und Δ*U*₃ des Spannungszustands *t*₁*, t*₂ und *t*₃ der Klemmenspannungen *U_{c}* und *Uₚ* über zumindest einen Spannungsschwellenwert und/oder der Abweichung Δ*R* der Widerstände *R*₁ und *R*₂ über zumindest einen Widerstandsschwellenwert, insbesondere einen jeweils mit der Umweltbedingung variierenden Spannungsschwellenwert und/oder Widerstandsschwellenwert, bestimmt das Batteriesteuergerät 5 den Anteil der defekten Batteriezellen 3 in der Gruppe 1, beispielsweise den Anteil der elektrisch von der Gruppe 1 getrennten Batteriezellen 3.

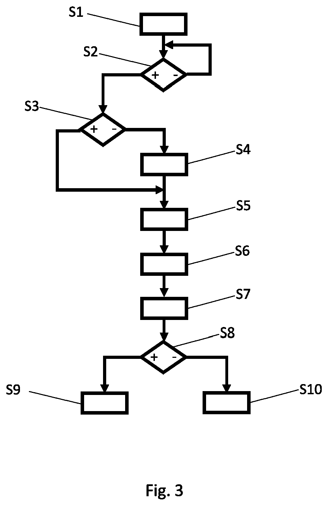

Insbesondere kann das Batteriesteuergerät 5 bei Überschreiten des Anteils der defekten Batteriezellen 3 in der Gruppe 1 über einen Anteilsschwellenwert die Gruppe 1 mittels der Schaltelemente 14 der Schaltanordnung 13 elektrisch von den anderen Gruppen 1 der Batterie 4 trennen. Somit kann die Auswirkung der defekten Batteriezellen 3 auf die gesunden Batteriezellen 2 reduziert werden. Ein Verfahren für das Batteriesteuergerät 5 ist in Figur 3 gezeigt.

Figur 3 zeigt eine schematische Darstellung eines Verfahrens zum Ermitteln des Anteils der defekten Batteriezellen in einer Gruppe, beispielsweise für ein Batteriesteuergerät 5. In einem ersten Schritt S1 wird bestimmt, dass sich die Batterie 4 in einem inaktiven Betriebszustand befindet. Beispielsweise kann eine Schwankung der Klemmenspannung *U_{c}* bestimmt werden und solange eine Summe der Abweichungen der Schwankungsbeträge der Klemmenspannung *U_{c}* einen Aktivitätsschwellenwert in einem Zeitintervall überschreitet, von einem aktiven Betriebszustand der Batterie 4 ausgegangen werden. Beispielsweise kann bei einer längeren Fahrt mit Zwischenhalten an Schnellladestationen oder durch Rekuperation die Summe der Schwankungsbeträge über dem Aktivitätsschwellenwert liegen, sodass das Verfahren zum Bestimmen des Anteils der defekten Batteriezellen 3 nicht startet. Wenn die Summe der Schwankungsbeträge der Klemmenspannung *U_{c}* den Aktivitätsschwellenwert in dem Zeitintervall unterschreitet, kann der Ruhezeitbeginn *t*₀ bestimmt werden.

Insbesondere kann der Ruhezeitbeginn *t*₀ dadurch bestimmt werden, wenn ein Signal empfangen wird, dass die Geschwindigkeit des Kraftfahrzeugs 11 null ist und eine Schließanlage des Kraftfahrzeugs 11 geschlossen ist. Ergänzend oder alternativ kann mittels der Messeinrichtung 5 ein Aufladestrom, welcher von der Ladevorrichtung zum Kraftfahrzeug fließt, gemessen und der Zeitpunkt, an welchem die Messung des Aufladestroms ungleich Null ist, als Ruhezeitbeginn *t*₀ bestimmt werden. Die Messeinrichtung 5 kann hierzu ergänzend für eine Strommessung ausgebildet sein. Ergänzend können die jeweiligen Gruppen mittels der Schaltelemente 14 der Schaltanordnung 13 von dem Batterieanschluss 12 elektrisch über die Dauer der Ruhezeit 9 getrennt werden.

In einem zweiten Schritt S2 wird bestimmt, ob ein Ladevorgang 8 durchgeführt werden soll. Beispielsweise kann bestimmen werden, dass ein Ladevorgang 8 vorliegt, sobald mittels der Messeinrichtung 15 ein Aufladestrom gemessen wird, welcher über den Batterieanschluss 12 zur Batterie 4 fließt. Ergänzend oder alternativ kann eine Benutzereingabe empfangen werden, dass ein Ladevorgang 8 gestartet wird. Solange kein Ladevorgang bestimmt wird, kann der Schritt S2 wiederholt werden. Die jeweilige Gruppe 1 der Batterie 4 kann mittels der Schaltelemente 14 der Schaltanordnung 13 mit dem Batterieanschluss 12 elektrisch verbunden werden, wenn eine Benutzereingabe empfangen wurde, dass ein Ladevorgang 8 durchgeführt werden soll.

In einem dritten Schritt S3 wird festgestellt, ob die Batterie 4 vor dem Ladestart, insbesondere vor der Ladestartzeit *tₗ*, eine ausreichende Ruhezeit 9 hatte. Während der Ruhezeit 9 können ergänzend die jeweiligen Gruppen 1 der Batterie 4 elektrisch von dem Batterieanschluss 12 mittels der Schaltelemente 14 der Schaltanordnung 13 getrennt werden, sodass die Gruppen 1 während der Ruhezeit 9 ruhen. Beispielsweise kann der Ruhezeitbeginn *t_{R}* mittels einer Auswertung der Signale zur Geschwindigkeit des Kraftfahrzeugs 11 und/oder einer Schließanlage des Kraftfahrzeugs 11 und/oder mittels einer Messung eines Zeitverlaufs des Aufladestroms bestimmt werden.

Insbesondere kann der Ruhezeitbeginn *t_{R}* als der Zeitpunkt bestimmt werden, an welchem die Geschwindigkeit des Kraftfahrzeugs 11 null ist und an welchem ein Messwert des Aufladestroms oder Entladestroms gleich 0 *A* ist. Ergänzend oder alternativ kann ein Signal von der Ladevorrichtung empfangen werden, dass das Kraftfahrzeug 11 mit der Ladevorrichtung elektrisch verbunden ist und der Zeitpunkt des Empfangs des besagten Signals als Ruhezeitbeginn *t_{R}* bestimmt werden.

Die Ruhezeit 9 kann zumindest teilweise eine Relaxationszeit *t_{R}* der Batterie 4 betragen. Die Ruhezeit 9 kann zumindest die Relaxationszeit *t_{R}* der Batterie 4 sein. Wenn ein Ladeziel *Uₕ* und/oder eine Ladezielzeit *tₕ* mittels einer Benutzereingabe empfangen werden, kann die Ladestartzeit *tₗ* mittels einer Prognose derart bestimmt werden, dass die Batterie 4 über die Ruhezeit 9 ab dem Ruhezeitbeginn *t_{R}* ruht und das Ladeziel *Uₕ* zur Ladezielzeit *tₕ* erreicht wird. Dazu kann beispielsweise mittels einer Bestimmung des Aufladestroms, insbesondere eines Aufladestromsollwertes, der Ladevorrichtung und dem Ladeziel *Uₕ* die voraussichtliche Ladedauer prognostiziert werden.

In einem vierten Schritt S4 wird der Ladevorgang 8 gestartet. Dabei kann ein konstanter Aufladestrom eingestellt werden. Insbesondere kann der Aufladestrom auf einen Aufladestromsollwert eingestellt werden, zu welchem die Batterie 4 geladen wird.

Während ein konstanter Aufladestrom mittels der Messeinrichtung 15 während des Ladevorgangs, beispielsweise zumindest in einer ersten Hälfte der Ladezeit ab der Ladestartzeit *tₗ*, gemessen wird, kann die Klemmenspannung *U_{c}* der jeweiligen Gruppe 1 der Batterie 4 zu verschiedenen Zeitpunkten *t*₁*, t*₂ und *t*₃ insbesondere periodisch, gemessen werden.

Beispielsweise kann während der Anlaufphase des Ladevorgangs, insbesondere während der Konstantstromphase, der Spannungszustand *t*₁*, t*₂ und *t*₃ der Klemmenspannung *U_{c}* unter zumindest einer Umweltbedingung bestimmt werden. Die Umweltbedingung kann als Parameter einen Aufladestrom oder Entladestrom und/oder eine Temperatur und/oder einen Ladezustand *Uₗ* der Batterie 4 und/oder die Ruhezeit 9 der Batterie 4 umfassen. Beispielsweise können für die Bestimmung der Umweltbedingung zum aktuellen Ladevorgang 8 ein Temperaturwert eines Temperatursensors des Kraftfahrzeugs 11 und/oder der Batterie 4 empfangen werden.

Ergänzend oder alternativ können im vierten Schritt S4 ein elektrischen Widerstand *R*₁ der Gruppe 1 oder einer anderen Gruppe 1 der Batterie 4 während dem Ladevorgang 8 bestimmt werden, beispielsweise zur Ladestartzeit *tₗ*.

In einem fünften Schritt S5 werden die Messdaten der Klemmenspannung *U_{c}* der Gruppe 1 und ergänzend zumindest einer anderen Gruppe 1 aus dem Ladevorgang 8 in einem Speicher gespeichert, insbesondere in einem Speicher des Batteriesteuergeräts 5. Die Messwerte werden als ein Spannungszustand der Klemmenspannung *U_{c}* in dem Speicher gespeichert.

Ergänzend oder alternativ können im fünften Schritt S5 ein Wert des elektrischen Widerstands *R*₁ der Gruppe 1 und/oder einer anderen Gruppe 1 der Batterie 4 in dem Speicher gespeichert werden. Der Spannungszustand *t*₁*, t*₂ und *t*₃ der Klemmenspannung *U_{c}* werden zusammen mit der Umweltbedingung in dem Speicher gespeichert.

Ergänzend oder alternativ umfasst die Umweltbedingung ein Parameterintervall, insbesondere ein Aufladestromintervall oder Entladestromintervall und/oder ein Temperaturintervall und/oder ein Ladezustandsintervall und/oder ein Ruhezeitintervall. Beispielsweise kann das Temperaturintervall ±5 Kelvin betragen und/oder das Ladezustandsintervall kann ± 20% betragen. Wenn beispielsweise der jeweilige Parameter der Umweltbedingung während des aktuellen Ladevorgangs 8 sich in dem jeweiligen Parameterintervall der Umweltbedingung aus dem vorherigen Ladevorgang 8 befindet, kann der Spannungszustand *t*₁*, t*₂ und *t*₃ der Klemmenspannung *U_{c}* der Umweltbedingung des Spannungszustands *t*₁*, t*₂ und *t*₃ der Klemmenspannung *Uₚ* aus dem vorherigen Ladevorgang 8 zugeordnet werden und insbesondere zusammen mit der Umweltbedingung kategorisiert in dem Speicher gespeichert werden. Wenn beispielsweise die Batterie 4 bei einer Temperatur von 5°C und einen Ladezustand von 30% während der Ruhezeit umfassend die Relaxationszeit *t_{R}* aufweist, kann der Spannungszustand der Klemmenspannung *U_{c}* während des Ladevorgangs 8 in dem Speicher kategorisiert unter dem zweiten Temperaturintervall und/oder dem ersten Ladezustandsintervall und/oder der Relaxationszeit *t_{R}* als Umweltbedingung gespeichert werden.

In einem sechsten Schritt S6 wird der Spannungszustand der Klemmenspannung *U_{c}* aus dem Ladevorgang 8 mit dem Spannungszustand der Klemmenspannung *Uₚ* derselben Gruppe 1 aus dem vorherigen Ladevorgang 8 unter derselben Umweltbedingung und/oder mit dem Spannungszustand der Klemmenspannung *Uₚ* einer anderen Gruppe 1 aus demselben oder dem vorherigen Ladevorgang 8 unter derselben Umweltbedingung verglichen.

Ergänzend oder alternativ kann im sechsten Schritt S6 der Wert des elektrischen Widerstands *R*₁ mit dem Wert des Widerstands *R*₂ derselben Gruppe 1 aus dem vorherigen Ladevorgang 8 und/oder mit dem Wert des Widerstands *R*₂ der anderen Gruppe 1 der Batterie 4 aus demselben oder dem vorherigen Ladevorgang 8 unter derselben Umweltbedingung verglichen werden.

In einem siebten Schritt S7 wird eine Abweichung Δ*U*₁*,* Δ*U*₂ und Δ*U*₃ des Spannungszustands *t*₁*, t*₂ und *t*₃ der Klemmenspannung *U_{c}* von dem Spannungszustand *t*₁*, t*₂ und *t*₃ der Klemmenspannung *Uₚ* berechnet und ergänzend wird die Abweichung Δ*U*₁*,* Δ*U*₂ und Δ*U*₃ in dem Speicher gespeichert. Ergänzend oder alternativ wird eine Abweichung Δ*R* des Widerstands *R*₁ von dem Widerstand *R*₂ beispielsweise zur Ladestartzeit *tₗ* berechnet und ergänzend Δ*R* in dem Speicher gespeichert.

In einem achten Schritt S8 wird mittels der Abweichung Δ*U*₁*,* Δ*U*₂ und Δ*U*₃ des Spannungszustands *t*₁*, t*₂ und *t*₃ der Klemmenspannung *U* und/oder der Abweichung Δ*R* des Widerstands *R* von zumindest einem jeweiligen Abweichungsschwellenwert, insbesondere zumindest einem Spannungsschwellenwert und/oder zumindest einem Widerstandsschwellenwert, der Anteil der defekten Batteriezellen in der Gruppe 1 mittels der Entscheidungsfunktion, insbesondere mittels der Entscheidungsmatrix, bestimmt.

Wenn der Anteil der defekten Batteriezellen den Anteilsschwellenwert nicht überschreitet, werden in einem neunten Schritt S9 die jeweiligen Schaltelemente 14 der Schaltanordnung 13 derart angesteuert, dass die Gruppe 1 elektrisch mit den anderen Gruppen 1 der Batterie 4 verbunden bleibt und der Ladevorgang 8 mit der Gruppe 1 fortgesetzt werden kann.

Wenn der Wenn der Anteil der defekten Batteriezellen den Anteilsschwellenwert überschreitet, wird in einem zehnten Schritt S10 die Gruppe 1 mittels zumindest eines Schaltelements 14 der Schaltanordnung 13 elektrisch von den anderen Gruppen 1 der Batterie 4 getrennt und/oder ein Aufladestrom oder Entladestrom begrenzt und/oder eine Warnmeldung ausgegeben.

Soweit anwendbar, können alle einzelnen Merkmale, die in den Ausführungsbeispielen dargestellt sind, miteinander kombiniert und/oder ausgetauscht werden, ohne den Bereich der Erfindung zu verlassen.

### Bezugszeichenliste

- 1: Gruppe
- 2: Batteriezelle
- 3: defekte Batteriezelle
- 4: Batterie
- 5: Batteriesteuergerät
- t₁, t₂, t₃: Spannungszustand
- *U, U*₁, *U*₂: Klemmenspannung
- 8: Ladevorgang
- 9: Ruhezeit
- *R*₁*, R*₂: elektrischer Widerstand
- 11: Kraftfahrzeug
- 12: Batterieanschluss
- 13: Schaltanordnung
- 14: Schaltelement
- 15: Messeinrichtung
- 16: Batteriezelltrennschalter (geschlossen)
- 17: Batteriezelltrennschalter (geöffnet)
- 18: Entladevorgang
- *Uₕ*: Ladeziel
- *Uₗ*: Ladezustand
- *t_{R}*: Relaxationszeit
- *tₗ*: Ladestartzeit
- *tₕ*: Ladezielzeit
- *t*₀: Ruhezeitbeginn
- S1: Schritt 1
- S2: Schritt 2
- S3: Schritt 3
- S4: Schritt 4
- S5: Schritt 5
- S6: Schritt 6
- S7: Schritt 7
- S8: Schritt 8
- S9: Schritt 9
- S10: Schritt 10
- S11: Schritt 11

## Patentansprüche

1. Verfahren zum Bestimmen eines Anteils defekter Batteriezellen (3) einer Gruppe (1) elektrisch parallel geschalteter Batteriezellen (2) in einer Batterie (4), wobei ein Spannungszustand (*t*₁*, t*₂*, t*₃) einer Klemmenspannung (*U, U*₁*, U*₂) der Gruppe (1) in Bezug auf einen Ladevorgang (8) und/oder in Bezug auf eine Relaxation der Batterie (4) unter einer Umweltbedingung bestimmt wird und eine Abweichung (Δ*U*₁*,* Δ*U*₂*,* Δ*U*₃*,* Δ*R*) und eine Veränderungsrate der Abweichung (Δ*U*₁*,* Δ*U*₂*,* Δ*U*₃*,* Δ*R*) des bestimmten Spannungszustands (*t*₁*, t*₂*, t*₃) der Klemmenspannung (*U, U*₁*, U*₂) von dem Spannungszustand (*t*₁, *t*₂*, t*₃) der Klemmenspannung (*U, U*₁*, U*₂) derselben Gruppe (1) aus einem vorherigen Ladevorgang (8) und/oder einer vorherigen Relaxation unter derselben Umweltbedingung berechnet wird, wobei aus der berechneten Abweichung und aus der Veränderungsrate der Abweichung (Δ*U*₁*,* Δ*U*₂*,* Δ*U*₃*,* Δ*R*) der Anteil der defekten Batteriezellen in der Gruppe bestimmt wird.

2. Verfahren zum Bestimmen eines Anteils defekter Batteriezellen (3) einer Gruppe (1) elektrisch parallel geschalteter Batteriezellen (2) in einer Batterie (4), wobei ein Spannungszustand (*t*₁, *t*₂, *t*₃) einer Klemmenspannung (*U, U*₁*, U*₂) der Gruppe (1) in Bezug auf einen Ladevorgang (8) und/oder in Bezug auf eine Relaxation der Batterie (4) unter einer Umweltbedingung bestimmt wird und eine Abweichung (Δ*U*₁*,* Δ*U*₂*,* Δ*U*₃*,* Δ*R*) und eine Veränderungsrate der Abweichung (Δ*U*₁*,* Δ*U*₂*,* Δ*U*₃*,* Δ*R*) des bestimmten Spannungszustands (*t*₁, *t*₂, *t*₃) der Klemmenspannung (*U, U*₁*, U*₂) von einem Spannungszustand (*t*₁*, t*₂*, t*₃) der Klemmenspannung (*U, U*₁*, U*₂) von zumindest einer anderen Gruppe (1) der Batterie (4) und/oder von einem Durchschnittswert des Spannungszustands (*t*₁, *t*₂, *t*₃) der jeweiligen Klemmenspannung (*U, U*₁*, U*₂) von zumindest zwei Gruppen (1) der Batterie (4) berechnet wird, wobei aus der berechneten Abweichung und aus der Veränderungsrate der Abweichung (Δ*U*₁*,* Δ*U*₂*,* Δ*U*₃*,* Δ*R*) der Anteil der defekten Batteriezellen in der Gruppe bestimmt wird.

3. Verfahren nach Anspruch 1 oder 2, **dadurch gekennzeichnet, dass** der Spannungszustand (*t*₁, *t*₂, *t*₃) der Klemmenspannung (*U, U*₁*,U*₂) der Gruppe (1) einerseits während des Ladevorgangs (8) und/oder der Relaxation und/oder andererseits jeweils vor und/oder nach dem Ladevorgang (8) und/oder der Relaxation bestimmt wird.

4. Verfahren nach einem der vorhergehenden Ansprüche, **dadurch gekennzeichnet, dass** das Bestimmen des Spannungszustands (*t*₁, *t*₂, *t*₃) der Klemmenspannung (*U, U*₁, *U*₂) ein Bestimmen eines Spannungsabfalls bei einem Beenden des Ladevorgangs (8) und/oder bei einem Beenden des Entladevorgangs umfasst.

5. Verfahren nach einem der vorhergehenden Ansprüche, **dadurch gekennzeichnet, dass** der Anteil der defekten Batteriezellen (3) in der Gruppe (1) mittels einer Entscheidungsfunktion aus der berechneten Abweichung bestimmt wird und/oder wobei mittels eines Vergleichs der berechneten Abweichung mit einem gespeicherten Abweichungsschwellenwert der Anteil der defekten Batteriezellen in der Gruppe bestimmt wird.

6. Verfahren nach einem der vorhergehenden Ansprüche, **dadurch gekennzeichnet, dass** bei einem Überschreiten der Abweichung (Δ*U*₁*,* Δ*U*₂*,* Δ*U*₃*,* Δ*R*) über einen von der Umweltbedingung abhängigen Abweichungsschwellenwert der Anteil der defekten Batteriezellen (3) in der Gruppe (1) bestimmt wird.

7. Verfahren nach einem der vorhergehenden Ansprüche, **dadurch gekennzeichnet, dass** bei einem Überschreiten des Anteils defekter Batteriezellen (3) über einen Anteilsschwellenwert die Gruppe (1) mittels einer Schaltanordnung (13) von der Batterie (4) elektrisch getrennt und/oder ein Aufladestrom oder ein Entladestrom begrenzt wird und/oder eine Warnmeldung ausgegeben wird.

8. Verfahren nach einem der vorhergehenden Ansprüche, **dadurch gekennzeichnet, dass** während des Ladevorgangs (8) der Spannungszustand (*t*₁*, t*₂*, t*₃) der Klemmenspannung (*U, U*₁*, U*₂) von derselben Gruppe (1) und/oder von der zumindest einen anderen Gruppe (1) unter der Umweltbedingung bestimmt wird und der bestimmte Spannungszustand (*t*₁*, t*₂*, t*₃) der Klemmenspannung (*U, U*₁*, U*₂) zusammen mit der Umweltbedingung in einem Speicher gespeichert wird.

9. Verfahren nach einem der vorhergehenden Ansprüche, **dadurch gekennzeichnet, dass** der Spannungszustand (*t*₁*, t*₂*, t*₃) der Klemmenspannung (*U, U*₁*, U*₂) von derselben Gruppe (1) und/oder von der zumindest einen anderen Gruppe (1) unter der Umweltbedingung während einer Anlaufphase des Ladevorgangs (8) bestimmt wird.

10. Verfahren nach einem der vorhergehenden Ansprüche, **dadurch gekennzeichnet, dass** die Umweltbedingung einen Aufladestrom oder Entladestrom und/oder eine Temperatur und/oder einen Ladezustand (*Uₗ*) der Batterie (4) und/oder eine Ruhezeit (9) der Batterie (4) umfasst.

11. Batteriesteuergerät (5) welches dazu eingerichtet ist, einen Anteil defekter Batteriezellen (3) einer Gruppe (1) elektrisch parallel geschalteter Batteriezellen (2) in einer Batterie (4) zu bestimmen, aufweisend eine Prozessoreinheit, welche dazu eingerichtet ist, mittels einer Messeinrichtung (15) einen Spannungszustand (*t*₁*, t*₂*, t*₃) einer Klemmenspannung (*U, U*₁*, U*₂) der Gruppe (1) in Bezug auf einen Ladevorgang (8) und/oder in Bezug auf eine Relaxation der Batterie (4) unter einer Umweltbedingung zu bestimmen und eine Abweichung (Δ*U*₁*,* Δ*U*₂*,* Δ*U*₃*,* Δ*R*) und eine Veränderungsrate der Abweichung (Δ*U*₁*,* Δ*U*₂*,* Δ*U*₃*,* Δ*R*) des mittels der Messeinrichtung bestimmten Spannungszustands (*t*₁, *t*₂, *t*₃) der Klemmenspannung (*U, U*₁, *U*₂) von einem in einem Speicher gespeicherten Spannungszustand (*t*₁, *t*₂, *t*₃) der Klemmenspannung (*U, U*₁*, U*₂) derselben Gruppe (1) aus einem vorherigen Ladevorgang (8) und/oder einer vorherigen Relaxation unter derselben Umweltbedingung und/oder von einem in einem Speicher gespeicherten Spannungszustand (*t*₁, *t*₂*, t*₃) der Klemmenspannung (*U, U*₁*, U*₂) von zumindest einer anderen Gruppe (1) der Batterie (4) und/oder von einem Durchschnittswert des Spannungszustands (*t*₁, *t*₂, *t*₃) der jeweiligen Klemmenspannung (*U, U*₁, *U*₂) von zumindest zwei Gruppen (1) der Batterie (4) zu berechnen, wobei die Prozessoreinheit dazu eingerichtet ist, aus der gemessenen Abweichung (Δ*U*₁*,* Δ*U*₂*,* Δ*U*₃*,* Δ*R*) und aus der Veränderungsrate der Abweichung (Δ*U*₁*,* Δ*U*₂*,* Δ*U*₃*,* Δ*R*) einen Anteil der defekten Batteriezellen in der Gruppe zu bestimmen.

12. Computerprogramm umfassend Befehle, die bei der Ausführung des Programms durch das Batteriesteuergerät (5) nach Anspruch 11 dieses veranlassen, das Verfahren nach einem der Ansprüche 1 bis 10 durchzuführen.

13. Computerlesbares Speichermedium, auf welchem das Computerprogramm nach Anspruch 12 gespeichert ist.

14. Batterie (4) umfassend das Batteriesteuergerät (5) nach Anspruch 11.

15. Kraftfahrzeug (11) umfassend die Batterie (4) nach Anspruch 14 und/oder das Batteriesteuergerät (5) nach Anspruch 11.

## Claims

1. Method for determining a proportion of defective battery cells (3) in a group (1) of battery cells (2) connected electrically in parallel in a battery (4), wherein a voltage state (t₁, t₂, t₃) of a terminal voltage (U, U₁, U₂) of the group (1) is determined in relation to a charging process (8) and/or in relation to a relaxation of the battery (4) under an environmental condition and a deviation (ΔU₁, ΔU₂, ΔU₃, ΔR) and a rate of change of the deviation (ΔU₁, ΔU₂, ΔU₃, ΔR) of the determined voltage state (t₁, t₂, t₃) of the terminal voltage (U, U₁, U₂) from the voltage state (t₁, t₂, t₃) of the terminal voltage (U, U₁, U₂) of the same group (1) from a previous charging process (8) and/or a previous relaxation under the same environmental condition are calculated, wherein the proportion of defective battery cells in the group is determined from the calculated deviation and from the rate of change of the deviation (ΔU₁, ΔU₂, ΔU₃, ΔR).

2. Method for determining a proportion of defective battery cells (3) in a group (1) of battery cells (2) connected electrically in parallel in a battery (4), wherein a voltage state (t₁, t₂, t₃) of a terminal voltage (U, U₁, U₂) of the group (1) is determined in relation to a charging process (8) and/or in relation to a relaxation of the battery (4) under an environmental condition and a deviation (ΔU₁, ΔU₂, ΔU₃, ΔR) and a rate of change of the deviation (ΔU₁, ΔU₂, ΔU₃, ΔR) of the determined voltage state (t₁, t₂, t₃) of the terminal voltage (U, U₁, U₂) from a voltage state (t₁, t₂, t₃) of the terminal voltage (U, U₁, U₂) of at least one other group (1) of the battery (4) and/or from an average value of the voltage state (t₁, t₂, t₃) of the respective terminal voltage (U, U₁, U₂) of at least two groups (1) of the battery (4) are calculated, wherein the proportion of defective battery cells in the group is determined from the calculated deviation and from the rate of change of the deviation (ΔU₁, ΔU₂, ΔU₃, ΔR).

3. Method according to Claim 1 or 2, **characterized in that** the voltage state (t₁, t₂, t₃) of the terminal voltage (U, U₁, U₂) of the group (1) is determined during the charging process (8) and/or the relaxation, on the one hand, and/or in each case before and/or after the charging process (8) and/or the relaxation, on the other hand.

4. Method according to one of the preceding claims, **characterized in that** determining the voltage state (t₁, t₂, t₃) of the terminal voltage (U, U₁, U₂) comprises determining a voltage drop when the charging process (8) ends and/or when the discharging process ends.

5. Method according to one of the preceding claims, **characterized in that** the proportion of defective battery cells (3) in the group (1) is determined from the calculated deviation by means of a decision function and/or wherein the proportion of defective battery cells in the group is determined by means of a comparison of the calculated deviation with a stored deviation threshold value.

6. Method according to one of the preceding claims, **characterized in that**, if the deviation (ΔU₁, ΔU₂, ΔU₃, ΔR) exceeds a deviation threshold value dependent on the environmental condition, the proportion of defective battery cells (3) in the group (1) is determined.

7. Method according to one of the preceding claims, **characterized in that**, if the proportion of defective battery cells (3) exceeds a proportion threshold value, the group (1) is electrically isolated from the battery (4) by means of a switching arrangement (13) and/or a charging current or a discharge current is limited and/or a warning message is output.

8. Method according to one of the preceding claims, **characterized in that**, during the charging process (8), the voltage state (t₁, t₂, t₃) of the terminal voltage (U, U₁, U₂) of the same group (1) and/or of the at least one other group (1) under the environmental condition is determined and the determined voltage state (t₁, t₂, t₃) of the terminal voltage (U, U₁, U₂) is stored in a memory together with the environmental condition.

9. Method according to one of the preceding claims, **characterized in that** the voltage state (t₁, t₂, t₃) of the terminal voltage (U, U₁, U₂) of the same group (1) and/or of the at least one other group (1) under the environmental condition is determined during a start-up phase of the charging process (8).

10. Method according to one of the preceding claims, **characterized in that** the environmental condition comprises a charging current or discharge current and/or a temperature and/or a state of charge (Uₗ) of the battery (4) and/or a rest period (9) of the battery (4).

11. Battery control unit (5), which is configured to determine a proportion of defective battery cells (3) in a group (1) of battery cells (2) connected electrically in parallel in a battery (4), having a processor unit, which is configured, by means of a measuring apparatus (15), to determine a voltage state (t₁, t₂, t₃) of a terminal voltage (U, U₁, U₂) of the group (1) in relation to a charging process (8) and/or in relation to a relaxation of the battery (4) under an environmental condition and to calculate a deviation (ΔU₁, ΔU₂, ΔU₃, ΔR) and a rate of change of the deviation (ΔU₁, ΔU₂, ΔU₃, ΔR) of the voltage state (t₁, t₂, t₃), determined by means of the measuring apparatus, of the terminal voltage (U, U₁, U₂) from a voltage state (t₁, t₂, t₃), stored in a memory, of the terminal voltage (U, U₁, U₂) of the same group (1) from a previous charging process (8) and/or a previous relaxation under the same environmental condition and/or from a voltage state (t₁, t₂, t₃), stored in a memory, of the terminal voltage (U, U₁, U₂) of at least one other group (1) of the battery (4) and/or from an average value of the voltage state (t₁, t₂, t₃) of the respective terminal voltage (U, U₁, U₂) of at least two groups (1) of the battery (4), wherein the processor unit is configured to determine a proportion of defective battery cells in the group from the measured deviation (ΔU₁, ΔU₂, ΔU₃, ΔR) and from the rate of change of the deviation (ΔU₁, ΔU₂, ΔU₃, ΔR).

12. Computer program comprising instructions, which, when the program is executed by the battery control unit (5) according to Claim 11, cause the latter to carry out the method according to one of Claims 1 to 10.

13. Computer-readable storage medium on which the computer program according to Claim 12 is stored.

14. Battery (4) comprising the battery control unit (5) according to Claim 11.

15. Motor vehicle (11) comprising the battery (4) according to Claim 14 and/or the battery control unit (5) according to Claim 11.

## Revendications

1. Procédé de détermination d'une proportion d'éléments de batterie défectueux (3) d'un groupe (1) d'éléments de batterie (2) connectés électriquement en parallèle dans une batterie (4), un état de tension (t₁, t₂, t₃) d'une tension aux bornes (U, U₁, U₂) du groupe (1) étant déterminé par rapport à un processus de charge (8) et/ou par rapport à une relaxation de la batterie (4) dans des conditions ambiantes, et un écart (ΔU₁, ΔU₂, ΔU₃, ΔR) et une vitesse de variation de l'écart (ΔU₁, ΔU₂, ΔU₃, ΔR) de l'état de tension (t₁, t₂, t₃) déterminé de la tension aux bornes (U, U₁, U₂) par rapport à l'état de tension (t₁, t₂, t₃) de la tension aux bornes (U, U₁, U₂) du même groupe (1) issu d'un processus de charge (8) antérieur et/ou d'une relaxation antérieure dans les mêmes conditions ambiantes étant calculés, la proportion des éléments de batterie défectueux dans le groupe étant déterminée à partir de l'écart calculé et de la vitesse de variation de l'écart (ΔU₁, ΔU₂, ΔU₃, ΔR).

2. Procédé de détermination d'une proportion d'éléments de batterie défectueux (3) d'un groupe (1) d'éléments de batterie (2) connectés électriquement en parallèle dans une batterie (4), un état de tension (t₁, t₂, t₃) d'une tension aux bornes (U, U₁, U₂) du groupe (1) étant déterminé par rapport à un processus de charge (8) et/ou par rapport à une relaxation de la batterie (4) dans des conditions ambiantes, et un écart (ΔU₁, ΔU₂, ΔU₃, ΔR) et une vitesse de variation de l'écart (ΔU₁, ΔU₂, ΔU₃, ΔR) de l'état de tension (t₁, t₂, t₃) déterminé de la tension aux bornes (U, U₁, U₂) par rapport à un état de tension (t₁, t₂, t₃) de la tension aux bornes (U, U₁, U₂) d'au moins un autre groupe (1) de la batterie (4) et/ou par rapport à une valeur moyenne de l'état de tension (t₁, t₂, t₃) de la tension aux bornes (U, U₁, U₂) respective d'au moins deux groupes (1) de la batterie (4) étant calculés, la proportion des éléments de batterie défectueux dans le groupe étant déterminée à partir de l'écart calculé et de la vitesse de variation de l'écart (ΔU₁, ΔU₂, ΔU₃, ΔR).

3. Procédé selon la revendication 1 ou 2, **caractérisé en ce que** l'état de tension (t₁, t₂, t₃) de la tension aux bornes (U, U₁, U₂) du groupe (1) est déterminé d'une part, pendant le processus de charge (8) et/ou la relaxation et/ou d'autre part, respectivement avant et/ou après le processus de charge (8) et/ou la relaxation.

4. Procédé selon l'une quelconque des revendications précédentes, **caractérisé en ce que** la détermination de l'état de tension (t₁, t₂, t₃) de la tension aux bornes (U, U₁, U₂) comprend une détermination d'une chute de tension lors d'une interruption du processus de charge (8) et/ou lors d'une interruption du processus de décharge.

5. Procédé selon l'une quelconque des revendications précédentes, **caractérisé en ce que** la proportion des éléments de batterie défectueux (3) dans le groupe (1) est déterminée au moyen de l'écart calculé au moyen d'une fonction de décision à partir de l'écart calculé, et/ou la proportion des éléments de batterie défectueux dans le groupe étant déterminée au moyen d'une comparaison de l'écart calculé avec une valeur seuil d'écart mémorisée.

6. Procédé selon l'une quelconque des revendications précédentes, **caractérisé en ce que** la proportion des éléments de batterie défectueux (3) dans le groupe (1) est déterminée lors d'un dépassement de l'écart (ΔU₁, ΔU₂, ΔU₃, ΔR) au-delà d'une valeur seuil d'écart dépendant des conditions ambiantes.

7. Procédé selon l'une quelconque des revendications précédentes, **caractérisé en ce que**, lors d'un dépassement de la proportion d'éléments de batterie défectueux (3) au-delà d'une valeur seuil de proportion, le groupe (1) est isolé électriquement de la batterie (4) au moyen d'un agencement de commutation (13), et/ou un courant de charge ou un courant de décharge est limité, et/ou un message d'avertissement est émis.

8. Procédé selon l'une quelconque des revendications précédentes, **caractérisé en ce que**, pendant le processus de charge (8), l'état de tension (t₁, t₂, t₃) de la tension aux bornes (U, U₁, U₂) du même groupe (1) et/ou d'au moins un autre groupe (1) est déterminé dans les conditions ambiantes, et l'état de tension (t₁, t₂, t₃) déterminé de la tension aux bornes (U, U₁, U₂) est mémorisé dans une mémoire conjointement avec les conditions ambiantes.

9. Procédé selon l'une quelconque des revendications précédentes, **caractérisé en ce que** l'état de tension (t₁, t₂, t₃) de la tension aux bornes (U, U₁, U₂) du même groupe (1) et/ou d'au moins un autre groupe (1) est déterminé dans les conditions ambiantes pendant une phase de démarrage du processus de charge (8).

10. Procédé selon l'une quelconque des revendications précédentes, **caractérisé en ce que** les conditions ambiantes comprennent un courant de charge ou de décharge et/ou une température et/ou un état de charge (Uₗ) de la batterie (4) et/ou un temps de repos (9) de la batterie (4).

11. Appareil de commande de batterie (5) conçu pour déterminer une proportion d'éléments de batterie défectueux (3) d'un groupe (1) d'éléments de batterie (2) connectés électriquement en parallèle dans une batterie (4), comprenant une unité de traitement qui est conçue pour déterminer, au moyen d'un dispositif de mesure (15), un état de tension (t₁, t₂, t₃) d'une tension aux bornes (U, U₁, U₂) du groupe (1) par rapport à un processus de charge (8) et/ou par rapport à une relaxation de la batterie (4) dans des conditions ambiantes, et pour calculer un écart (ΔU₁, ΔU₂, ΔU₃, ΔR) et une vitesse de variation de l'écart (ΔU₁, ΔU₂, ΔU₃, ΔR) de l'état de tension (t₁, t₂, t₃), déterminé au moyen du dispositif de mesure, de la tension aux bornes (U, U₁, U₂) par rapport à un état de tension (t₁, t₂, t₃), mémorisé dans une mémoire, de la tension aux bornes (U, U₁, U₂) du même groupe (1) et issu d'un processus de charge (8) antérieur et/ou d'une relaxation antérieure dans les mêmes conditions ambiantes et/ou par rapport à un état de tension (t₁, t₂, t₃), mémorisé dans une mémoire, de la tension aux bornes (U, U₁, U₂) d'au moins un autre groupe (1) de la batterie (4) et/ou par rapport à une valeur moyenne de l'état de tension (t₁, t₂, t₃) de la tension aux bornes (U, U₁, U₂) respective d'au moins deux groupes (1) de la batterie (4), l'unité de traitement étant conçue pour déterminer une proportion des éléments de batterie défectueux dans le groupe à partir de l'écart mesuré (ΔU₁, ΔU₂, ΔU₃, ΔR) et de la vitesse de variation de l'écart (ΔU₁, ΔU₂, ΔU₃, ΔR).

12. Programme informatique comprenant des instructions qui, lors de l'exécution du programme par l'appareil de commande de batterie (5) selon la revendication 11, amènent ce dernier à mettre en œuvre le procédé selon l'une quelconque des revendications 1 à 10.

13. Support de stockage lisible par ordinateur sur lequel est mémorisé le programme informatique selon la revendication 12.

14. Batterie (4) comprenant l'appareil de commande de batterie (5) selon la revendication 11.

15. Véhicule à moteur (11) comprenant la batterie (4) selon la revendication 14 et/ou l'appareil de commande de batterie (5) selon la revendication 11.
